(19) Europäisches Patentamt
European Patent Office
Office européen des brevets

(11) **EP 4 683 230 A1**

(12) **EUROPEAN PATENT APPLICATION**
published in accordance with Art. 153(4) EPC

(43) Date of publication:
**21.01.2026 Bulletin 2026/04**

(21) Application number: **24822247.3**

(22) Date of filing: **07.02.2024**

(51) International Patent Classification (IPC):
**H03M 13/13** (2006.01)   **H04L 1/00** (2006.01)

(52) Cooperative Patent Classification (CPC):
**H03M 13/13; H04L 1/00**

(86) International application number:
**PCT/CN2024/076806**

(87) International publication number:
**WO 2024/255288 (19.12.2024 Gazette 2024/51)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **14.06.2023 CN 202310709616**

(71) Applicant: **ZTE Corporation**
**Shenzhen, Guangdong 518057 (CN)**

(72) Inventors:
• **DONG, Yanfei**
  **Shenzhen, Guangdong 518057 (CN)**
• **XU, Jin**
  **Shenzhen, Guangdong 518057 (CN)**
• **LIANG, Chulong**
  **Shenzhen, Guangdong 518057 (CN)**
• **FU, Qiang**
  **Shenzhen, Guangdong 518057 (CN)**
• **KANG, Jian**
  **Shenzhen, Guangdong 518057 (CN)**

(74) Representative: **Ziebig Hengelhaupt Intellectual Property Attorneys**
**Patentanwaltskanzlei PartGmbB**
**Leipziger Straße 49**
**10117 Berlin (DE)**

(54) **CODING METHOD AND APPARATUS, AND COMPUTER-READABLE STORAGE MEDIUM**

(57)     The present application relates to the technical field of communications, and relates to a coding method and apparatus, and a computer-readable storage medium. The method of the present application comprises: on the basis of a target adjustment direction, adjusting the number of information bit indexes of a first sub-code, which does not support decoding implemented by means of a preset decoding algorithm, among a plurality of subcodes of a polarization sequence, wherein the target adjustment direction comprises increasing the number of information bit indexes of the first sub-code or reducing the number of information bit indexes of the first subcode; on the basis of the adjusted polarization sequence and an input bit sequence, obtaining a sequence to be coded; and on the basis of a generation matrix, coding the sequence to be coded, so as to obtain a coded sequence, and sending the coded sequence. The method provided in the present application can reduce the number of bit indexes, which need adjustment, in a polarization sequence, thereby improving the performance of decoding. The present application can be used in a wireless communication process.

Acquire a plurality of subcodes of a polar sequence — S201

Traverse each subcode of the plurality of subcodes to determine whether the subcode supports to be decoded by a preset decoding algorithm, in response that the subcode supports to be decoded by the preset decoding algorithm, determine whether a next subcode supports to be decoded by the preset decoding algorithm; in response that the subcode does not support to be decoded by the preset decoding algorithm, perform S203 — S202

Adjust a first subcode that does not support to be decoded by the preset decoding algorithm in the polar sequence, and a number of information bit indexes of the first subcode, based on a target adjustment direction — S203

obtain a to-be-encoded sequence based on the polar sequence that has been adjusted and an input bit sequence — S204

encode the to-be-encoded sequence based on a generation matrix to obtain an encoded sequence, and send the encoded sequence — S205

FIG. 2

**Description**

The present disclosure claims priority to a Chinese patent application No. 202310709616.5 filed on June 14, 2023, the entire content of which is incorporated in the present disclosure by reference.

TECHNICAL FIELD

The present disclosure relates to the field of communication technologies, in particular to an encoding method and apparatus, and a computer-readable storage medium.

BACKGROUND

Currently, a major research direction for a high-throughput decoder for polar codes is the use of a fast successive cancellation (Fast successive cancellation, Fast-SC) algorithm, and the Fast-SC may quickly decode specific types of subcodes. For example, subcodes of the types of code rates of 0, 1/16, 2/16, 3/16, 13/16, 14/16, 15/16, and 1 respectively, etc., may be quickly decoded.

However, the problem of fast decoding for seven types of subcodes with code rates of 4/16, 5/16, 6/16, 8/16, 9/16, 10/16, and 12/16 has still been unsolved. For the Fast-SC decoders for polar codes, the existence of subcodes that cannot be quickly decoded is an obstacle to further improving decoding performance. In order to further reduce the decoding delay of the Fast-SC decoder, a solution is to reduce the number of subcodes with code rates of 4/16, 5/16, 6/16, 8/16, 9/16, 10/16, and 12/16 by adjusting positions of indexes in a polar sequence. Therefore, how to adjust positions of bit indexes in the polar sequence, reduce the number of subcodes that do not support the Fast-SC algorithm decoding, and improve decoding performance, has become an urgent problem to be solved.

SUMMARY

Embodiments of the present disclosure provide an encoding method and apparatus, and a computer-readable storage medium, to reduce the number of bit indexes that need to be adjusted in a polar sequence and improve decoding performance.

In an aspect, an encoding method is provided, and includes: adjusting a number of information bit indexes of a first subcode that does not support to be decoded by a preset decoding algorithm among a plurality of subcodes of a polar sequence, based on a target adjustment direction; where the target adjustment direction includes increasing the number of information bit indexes of the first subcode or decreasing the number of information bit indexes of the first subcode; obtaining a sequence to be encoded based on the polar sequence that has been adjusted and the input bit sequence; and encoding the sequence to be encoded based on the generation matrix to obtain an encoded sequence, and sending the encoded sequence.

In another aspect, an encoding apparatus is provided, and includes: a processing unit, and a sending unit.

The processing unit is configured to adjust a number of information bit indexes of a first subcode that does not support to be decoded by a preset decoding algorithm among a plurality of subcodes of a polar sequence, based on a target adjustment direction; where the target adjustment direction includes increasing the number of information bit indexes of the first subcode or decreasing the number of information bit indexes of the first subcode; obtain a sequence to be encoded based on the polar sequence that has been adjusted and the input bit sequence; and encode the sequence to be encoded based on the generation matrix to obtain an encoded sequence.

The sending unit is configured to send the encoded sequence.

In yet another aspect, an encoding apparatus is provided, and includes: a memory and a processor; the memory is coupled to the processor; the memory is configured to store a computer program; the processor, when executing the computer program, implements the encoding method described in any one of the above-mentioned embodiments.

In yet another aspect, a communication system is provided, and includes the encoding apparatus described in any one of the above-mentioned embodiments and a decoding apparatus. The encoding apparatus is configured to implement the encoding method described in any one of the above-mentioned embodiments, and the decoding apparatus is configured to decode the encoded sequence sent from the encoding apparatus based on a preset decoding algorithm.

In yet another aspect, a computer-readable storage medium is provided, and computer program instructions are on the computer-readable storage medium, and the computer program instructions, when executed by a processor, implement the encoding method described in any one of the above-mentioned embodiments.

In yet another aspect, a computer program product is provided, the computer program product includes computer program instructions, and the computer program instructions, when executed by a processor, implement the encoding method described in any one of the above-mentioned embodiments.

In the embodiments of the present disclosure, for a subcode that does not support to be decoded by the preset decoding algorithm in the polar sequence, the subcode may be adjusted to support to be decoded by the preset decoding algorithm through increasing the number of information bit indexes of the subcode or decreasing the number of information bit indexes of the subcode, and after the adjustment, an encoding processing may be performed on it, to obtain an encoded sequence which then is sent. In this way, the adjustment direction of the subcode is flexibly designed, and the information bit indexes of the subcode are adjusted adaptively based on the adjustment direction matched with the subcode, so that the adjustment direction is no longer fixed simply, thereby improving the adjustment efficiency of the subcode and then improving the decoding performance.

## BRIEF DESCRIPTION OF THE DRAWINGS

In order to more clearly illustrate the technical solutions in the present disclosure, the drawings that need to be used in some embodiments of the present disclosure will be briefly introduced below, and obviously, the drawings described below are only drawings of some embodiments of the present disclosure. For those ordinary skilled in the art, other drawings may be obtained according to these drawings.

FIG. 1A is a schematic diagram of an architecture of a communication system provided in some embodiments of the present disclosure.
FIG. 1B is a schematic diagram of a data transmission between a sending end and a receiving end provided in some embodiments of the present disclosure.
FIG. 2 is a schematic flowchart of an encoding method provided in some embodiments of the present disclosure.
FIG. 3A is a schematic diagram of a performance simulation provided in some embodiments of the present disclosure.
FIG. 3B is a schematic diagram of another performance simulation provided in some embodiments of the present disclosure.
FIG. 4A is a schematic diagram of yet another performance simulation provided in some embodiments of the present disclosure.
FIG. 4B is a schematic diagram of yet another performance simulation provided in some embodiments of the present disclosure.
FIG. 5 is a schematic flowchart of another encoding method provided in some embodiments of the present disclosure.
FIG. 6 is a schematic flowchart of yet another encoding method provided in some embodiments of the present disclosure.
FIG. 7 is a structural diagram of an encoding apparatus provided in some embodiments of the present application.
FIG. 8 is a structural diagram of another encoding apparatus provided in some embodiments of the present application.

## DETAILED DESCRIPTION

Before introducing the embodiments of the present disclosure, some technical terms related to the present disclosure are described and explained as follows.

Polar code encoding is an encoding method that uses polar effects to perform channel encoding which enables to achieve a symmetric channel capacity I(W). A basic idea of polar code encoding is to: for a plurality of polar channels, establish a selection mode for information bits, so that each information bit may independently pass through a parallel polar channel, and send information bits that are actually to be transmitted on polar channels with a channel symmetric capacity I(W)≈1 or a Bhattacharyya parameter Z(W) ≈ 0. On remaining polar channels other than those with a channel symmetric capacity I(W)≈1 or a Bhattacharyya parameter Z(W)≈0, bits or fixed bits that are known to both a sender and a receiver may be transmitted. Here, polar channels with a channel symmetric capacity I(W)≈1 or a Bhattacharyya parameter Z(W)≈0 may be referred to as information channel sets, information sets, or information bits, bits transmitted on which may be referred to as information bits, and the remaining polar channels may be referred to as frozen channel sets, frozen sets, or frozen bits, bits transmitted on which may be referred to as frozen bits.

A polar sequence may be referred to as polar codes or a polar code sequence. Specifically, the polar sequence includes indexes of polar channels (or referred to as bit indexes). The polar sequence may include an information bit index set and a frozen bit index set, and the information bit index set is used to indicate which polar channels are used to transmit channel bits, and the frozen bit index set is used to indicate which polar channels are used to transmit frozen bits. Taking N polar channels as an example, the polar sequence includes N indexes corresponding to the N polar channels, the indexes may be serial numbers of the polar channels, or the like, and an index indicates a polar channel. It should be understood that the present disclosure does not limit the naming of the polar channel, and the polar channel may also be referred to as a channel or a transmission channel, etc., which is not limited herein. The polar channel described as the present disclosure may be a Gaussian white noise (Additive White Gaussian Noise, AWGN) channel.

The process for processing the polar code encoding may include: for input information bits with a length of K, mapping the input information bits one-to-one onto the polar sequence with a length of N according to the information bit index set of the polar sequence, and uniformly setting the remaining N-K bits of frozen bit indexes as "0" or "1" according to predefined values. K is an integer less than the number N of polar channels. It should be understood that the value of the frozen bit index has no impact on channel transmission effects. After that, the mapped sequence is input to a polar code encoder to complete the polar code encoding.

Corresponding to the polar code encoding, on a decoder side, the polar codes may be decoded by using the successive-cancellation (Successive-cancellation, SC) decoding algorithm. In the SC decoding algorithm, code elements are decoded continuously in sequence when decoding, and if the code length of the polar codes is long, the decoding delay will be large, thereby reducing the throughput of the communication system. However, when the code length of the polar codes is long, the encoding performance is relatively good. In order to balance the code length of the polar codes and the decoding delay on the decoding side, currently, when decoding, the fast successive cancellation (Fast-SC) algorithm is used for decoding, multiple kinds of subcodes are used to represent the polar codes, and the fast decoding is implemented through the parallel processing on the respective subcodes, thereby providing a high-throughput decoder.

The Fast-SC algorithm may quickly decode a specific type of subcodes. For example, the Fast-SC algorithm may quickly decode eight types of subcodes, which are Rate-0, repetition (Repetition, REP), REP-2, parity checked repetition (Parity checked repetition, PCR), repeated parity check (Repeated parity check, RPC), SPC-2, single-parity-check (Single-Parity-Check, SPC), and Rate-1, respectively. For example, in a case where a decoding parallelism is set as 16 (i.e., the code length is 16), code rates of the eight types of subcodes that the Fast-SC algorithm can process are 0, 1/16, 2/16, 3/16, 13/16, 14/16, 15/16, and 1, respectively. In addition, by replacing subcodes with code rates of 7/16 and 11/16 with BCH codes, the problem of fast decoding of subcodes with code rates of 7/16 and 11/16 in the Fast-SC algorithm may be solved, but the problem of fast decoding of seven types of subcodes with code rates of 4/16, 5/16, 6/16, 8/16, 9/16, 10/16, and 12/16 has still been unsolved. For the Fast-SC decoder of polar codes, the existence of subcodes that cannot be decoded quickly is an obstacle to further improving the throughput of the decoder. In order to further reduce the decoding delay of the Fast-SC decoder, index types of bit indexes in the polar sequence are adjusted to reduce the number of subcodes with code rates of 4/16, 5/16, 6/16, 8/16, 9/16, 10/16, and 12/16 as much as possible, for example, reduce to 0.

Currently, an implementation method for adjusting bit indexes in the polar sequence is to: set all frozen bit indexes in the polar sequence as an active state, and segment polar code position information with a length of N at equal lengths according to a configured parallelism M, i.e., each segment is a subcode. The segment number of subcodes is $N/M$; serial detection on whether the $N/M$ subcodes may be fastly decoded is performed, and if the detected $N/M$ subcodes are subcodes that may not be fastly decoded, the code rates need to be adjusted. In the process of adjusting a code rate, an information bit index with lowest reliability in a current subcode is represented as i, and a frozen bit index with highest reliability in the active state in all subcodes after the current subcode is represented as j, and the number of information bit indexes of a subcode in which the frozen bit index with the index j is located, is $k_j$; in the process of adjusting the code rate, it is to be determined whether $k_j \geq 11$ $k_j \geq 11$ and $k_j < 16$ $k_j < 16$ or whether $k_j < 3$ $k_j < 3$ is true. If true, the position with the index i is changed to the frozen bit index, and meanwhile, the frozen bit index with the index j is changed to the information bit index; otherwise, the frozen bit index with the index j is set as an inactive state, and then the process of adjusting the code rate is repeated.

Although the current scheme may reduce the number of subcodes that do not support to be decoded by the Fast-SC decoder as much as possible, by adjusting the code rates of the subcodes in the polar sequence. However, in this scheme, the information bit index in the subcode is adjusted to the frozen bit index, so that the adjustment direction is single, and the frozen bit index is selected from all subcodes after the current subcode to exchange the index type, so that the selecting range is limited, resulting in a large number of bit indexes that need to be adjusted and a high number of adjustments, thereby reducing the adjustment efficiency of the subcode in the polar sequence and affects the decoding performance of the Fast-SC algorithm.

In order to solve the above-mentioned technical problems and improve the decoding performance of the Fast-SC algorithm, the present disclosure provides an encoding method to: adjust a number of information bit indexes of a first subcode that does not support to be decoded by a preset decoding algorithm among a plurality of subcodes of a polar sequence, based on a target adjustment direction; where the target adjustment direction includes increasing the number of information bit indexes of the first subcode or decreasing the number of information bit indexes of the first subcode; and encode based on the polar sequence that has been adjusted and send. In this way, the adjustment direction of the subcode is flexibly designed, and the information bit indexes of the subcode are adjusted adaptively based on the adjustment direction matched with the subcode, so that the adjustment direction is no longer fixed simply, thereby effectively reducing the number of bit indexes that need to be adjusted, and so that the requirement for the subcode to be decoded by the preset decoding algorithm may be met in a case of the fewer number of adjustments, thereby improving the adjustment efficiency of the subcode, and enabling that all subcodes support to be decoded by the preset decoding algorithm on the basis of the improved adjustment efficiency, and further improving the decoding performance.

In addition, in the present disclosure, a target bit index is searched from d bit indexes with reliability close to reliability of a to-be-adjusted bit index other than the first subcode (such as all bit indexes in the polar sequence other than the first subcode), and index types of the to-be-adjusted bit index and the target bit index are adjusted. In this way, the matched target bit index may be selected from the index sequence other than the first subcode, and since the candidate index sequence may include segments after a segment in which the first subcode is located and may also include segments before the segment in which the first subcode is located, the selecting range of the target index bit is expanded and is no longer limited to frozen bit indexes after the segment in which the first subcode is located as the selecting range, so that the matched target bit index may be found more efficiently and accurately from the candidate index sequence, reducing the number of bit indexes that need to be adjusted. Meanwhile, it is maintained that the information bits are transmitted on polar channels with high channel quality (or high reliability) both before and after the bit index is adjusted, thereby ensuring the transmission performance of the entire communication system.

The technical solutions of the present disclosure will be described clearly and completely below in conjunction with the drawings in the present disclosure, and obviously, the described embodiments are only a part of the embodiments of the present disclosure, not all of the embodiments. Based on the embodiments of the present disclosure, all other embodiments obtained by those ordinary skilled in the art without making inventive efforts fall within the scope of protection of the present disclosure.

It should be noted that in the present disclosure, terms such as "exemplary (exemplarily)" or "for example (such as, e.g.)" are used to represent examples, illustrations, or descriptions. Any embodiment or design solution described with "exemplary (exemplarily)" or "for example (such as, e.g.)" in the present disclosure should not be interpreted as being more preferred or advantageous than other embodiments or design solutions. Specifically, the use of the terms such as "exemplary (exemplarily)" or "for example (such as, e.g.)", etc., is intended to present related concepts in a specific manner.

Hereinafter, the terms such as "first", "second" are used only for descriptive purposes and cannot be construed as indicating or implying relative importance or implicitly indicating the number of the indicated technical features. Thus, features limited with "first", "second" may explicitly or implicitly include one or more of the features. In the description of the present disclosure, unless otherwise specified, the symbol "/" means "or", and for example, A/B may represent A or B. Herein, "and/or" is only used to describe an associated relationship between associated objects, representing that there may be three relationships, and for example, A and/or B may represents three cases: only A, both A and B, and only B. Additionally, "at least one" means one or more, and "multiple/plurality of" means two or more.

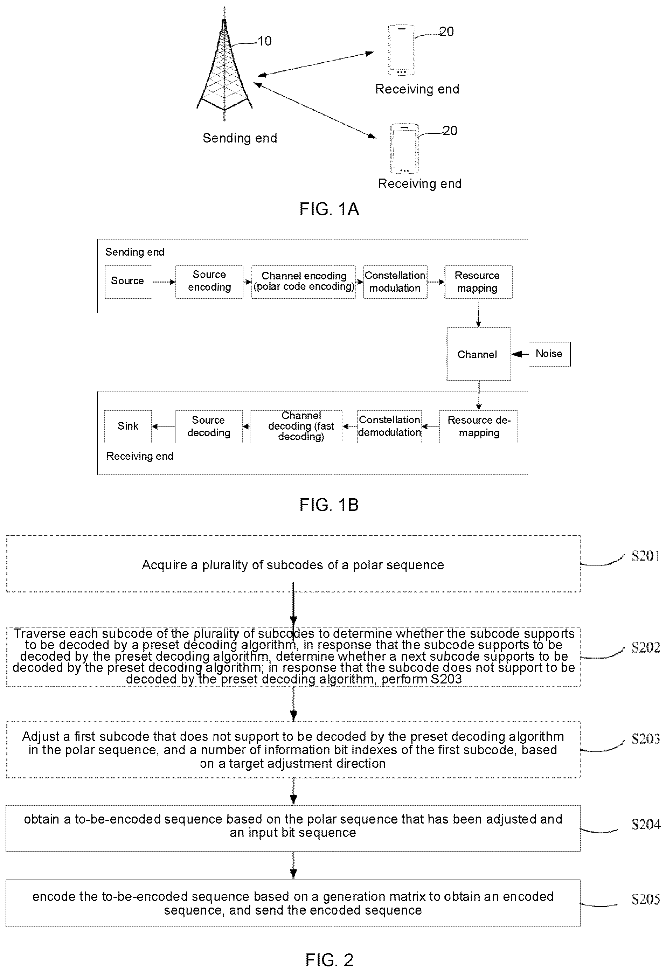

The technical solutions of the embodiments of the present disclosure may be applied to various mobile communication systems that support polar code encoding, such as: a universal mobile communication system (universal mobile telecommunication system, UMTS), a worldwide interoperability for microwave access (WiMAX) communication system, a 4th generation (4G) system, a long term evolution (LTE) system, and a future fifth generation (5G) communication system, a new radio (NR) system, an NR-vehicle-to-everything (V2X) system, or other next-generation communication systems, etc., and may also be applied to wireless local area networks (WLANs) or the like that support polar code encoding-Fast-SC algorithm. The embodiments of the present disclosure are described by taking a communication system shown in FIG. 1A as an example.

FIG. 1A is a schematic diagram of an architecture of a communication system provided in the embodiments of the present disclosure. As shown in FIG. 1A, the communication system 100 may include a sending end 10 and one or more receiving ends 20. Data and/or information may be transmitted between the sending end 10 and the receiving end(s) 20 through a polar channel. Specifically, the sending end 10 is equipped with the method for performing the encoding described in the present disclosure, and the sending end 10 may be integrated with the encoding apparatus. The receiving end is configured to receive the encoded sequence and is equipped with a decoding function, and the receiving end 20 may be integrated with a decoding apparatus.

The sending end 10 may provide communication services to the receiving end 20, and the sending end 10 may also communicate with a core network.

In some embodiments, the sending end 10 may be a base station, and the base station is configured to provide radio access services to a plurality of terminals. Specifically, a base station provides a service coverage area (also referred to as a cell). Terminals entering this area may communicate with the base station via wireless signals, to receive the radio access services provided by the base station. Specifically, the base station may be a base station or an evolutionary base station (an evolutionary node B, eNB or eNodeB) in LTE or long term evolution advanced (LTEA), a base station device in a 5G network, or a base station in a future communication system, etc., and the base station may include various network-side devices such as various macro base stations, micro base stations, home base stations, remote radio units, reconfigurable intelligent surfaces (RIS), routers, and wireless fidelity (WIFI) devices, etc.

In some embodiments, the receiving end 20 may be a terminal, and the terminal may be a device with a wireless transceiver function, and may be deployed on land, including indoor or outdoor, handheld, wearable, or in-vehicle; the terminal device may also be deployed on water (e.g., on a steamship, etc.); the terminal device may also be deployed in air (e.g., on an airplane, on a balloon, or on a satellite, etc.). The terminal may be a mobile phone, a pad, a computer with a wireless transceiver function, a virtual reality (VR) terminal, an augmented reality (AR) terminal, a wireless terminal in industrial control, a wireless terminal in self-driving, a wireless terminal in remote medical, a wireless terminal in smart grid, a wireless terminal in transportation safety, a wireless terminal in smart city, a wireless terminal in smart home, or the like. The embodiments of the present disclosure do not limit the application scenarios. The terminal may sometimes be referred to as a user, a user equipment (User Equipment, UE), an access terminal, a UE unit, a UE station, a mobile station, a mobile platform, a remote station, a remote terminal, a mobile device, a UE terminal, a wireless communication device, a UE agent, or a UE apparatus, etc., which is not limited in the embodiments of the present disclosure.

It should be noted that in the embodiments of the present disclosure, the receiving end and the sending end are relative concepts, the receiving end may refer to a device that performs polar code encoding on information bits and sends the encoded polar code to the peer end, and the receiving end may refer to a device that receives the encoded polar code and decodes information bits encoded from the received polar code. As shown in FIG. 1B, there is a schematic diagram of a data transmission between a sending end and a receiving end. As shown in FIG. 1B, the sending end sends a signal obtained from source encoding, channel encoding, constellation modulation, and resource mapping of a source (i.e., to-be-transmitted information bits), to the receiving end through a channel. After receiving the signal, the receiving end performs resource de-mapping, constellation demodulation, channel decoding, and source decoding on the signal to obtain a sink, i.e., the restored source.

The channel in FIG. 1B may be an AWGN channel. The encoding method provided in the present disclosure may be used for the channel encoding in FIG. 1B, and the channel encoding may be referred to as polar code encoding. Correspondingly, the channel decoding in FIG. 1B may support the use of a preset decoding algorithm (such as the Fast-SC algorithm) to decode the encoded sequence output by the channel encoding.

It should be understood that the communication system shown in FIG. 1A is only for more clearly illustrating the technical solutions of the present disclosure, but does not constitute a limitation on the present disclosure, and those ordinary skilled in the art may know that with the evolution of network architectures and the emergence of new service scenarios, the technical solutions provided in the present disclosure is also applicable to similar technical problems. In addition, FIG. 1A is an exemplary framework diagram, and the number of nodes included in FIG. 1A is not limited, and in addition to the functional nodes shown in FIG. 1A, the communication system may also include other nodes, such as: a gateway device, an application server, etc., which is not limited thereto.

An encoding method provided in the embodiments of the present disclosure is described below in conjunction with the communication system shown in FIG. 1A. The actions, terms or the like involved between the various embodiments of the present disclosure may refer to each other. The message names or the parameter names in messages interacted between various devices in the embodiments of the present disclosure are only an example, and other names may also be used in specific implementations, which are not limited thereto.

FIG. 2 is an encoding method provided in the embodiments of the present disclosure, and as shown in FIG. 2, the method may be performed by the sending end in FIG. 1A, and specifically, the method may be performed by the encoding apparatus in the sending end, and the method may include:

S201, acquire a plurality of subcodes of a polar sequence.

The polar sequence may include a plurality of bit indexes, and for example, the polar sequence may include N bit indexes, a bit index indicates a polar channel, reliability of the bit index is positively proportional to a channel capacity (or referred to as a channel symmetric capacity) of the polar channel indicated by the bit index, and the higher the reliability of the bit index, the larger the channel capacity of the polar channel indicated by the bit index. For example, the channel symmetric capacity of the polar channel indicated by the bit index with the highest reliability, $I(W) \approx 1$, and conversely, the lower the reliability of the bit index, the smaller the channel capacity of the polar channel indicated by the bit index. Specifically, the bit index may be a serial number or a channel serial number of the polar channel. The value of N may be set according to requirements, and for example, N may be set according to a size of an encoding block or a code length, and N $\leq$ the number of polar channels in the communication system. Taking the 5G NR communication system as an example, a maximum code length of the polar sequence is 1024, that is, N_{max}=1024, and the polar sequence corresponding to the 5G NR communication system may include $N = 2^n (n \leq 10)$ bit indexes.

Among a plurality of bit indexes included in the polar sequence, there is at least one type of bit indexes as follows: an information bit index and a frozen bit index, and for example, all of the plurality of bit indexes are information bit indexes, or the plurality of bit indexes include an information bit index and a frozen bit index, or all of the plurality of bit indexes are frozen bit indexes. A set of information bit indexes included in the polar sequence may be referred to as an information bit index set, and a set of frozen bit indexes included in the polar sequence may be referred to as a bit index set.

In the present disclosure, the information bit index indicates a polar channel that can transmit an information bit, and the frozen bit index indicates a polar channel that cannot transmit an information bit. Exemplarily, the bit index may be determined as an information bit index or a frozen bit index according to the reliability of the bit index. For example, the bit index with high reliability may be determined as an information bit index, and the bit index with low reliability may be determined as a frozen bit index. Optionally, in a case where a plurality of bit indexes in the polar sequence are sorted in order of reliability from high to low or from low to high, K bit indexes with the highest reliability are used as information bit indexes, and the other bit indexes other than the K information bit indexes are used as frozen bit indexes. The value of K is related to a code rate of the polar sequence, and the code rate may be preset, and a ratio value of the number of information bit indexes K to the code length of the polar sequence needs to meet the preset code rate.

In a possible implementation, the polar sequence is pre-specified, for example, pre-specified by a protocol. Taking the 5G NR communication system as an example, the polar sequence may be acquired from a protocol standard corresponding to the 5G NR communication system.

Take a polar sequence $\mathbf{Q}_0^{N_{max}-1} = \{Q_0^{N_{max}}, Q_1^{N_{max}}, ..., Q_{N_{max}-1}^{N_{max}}\}$ corresponding to the 5G NR communication system as an example, where $0 \le Q_i^{N_{max}} \le N_{max}-1$ in the polar sequence represents an i-th bit index, $N_{max}$ = 1024. $W(Q_i^{N_{max}})$ represents the reliability of the bit index $Q_i^{N_{max}}$. The polar sequence $\mathbf{Q}_0^{N_{max}}$ is sorted from low to high (or referred to as sorted in ascending order) according to reliability of the bit indexes, that is, $W(Q_0^{N_{max}}) < W(Q_1^{N_{max}}) < ... < W(Q_{N_{max}-1}^{N_{max}})$. For any code block encoded as N bits, the polar sequence $\mathbf{Q}_0^{N} = \{Q_0^{N}, Q_1^{N}, Q_2^{N}, ..., Q_{N-1}^{N}\}$ needs to be used. The polar sequence $\mathbf{Q}_0^{N} = \{Q_0^{N}, Q_1^{N}, Q_2^{N}, ..., Q_{N-1}^{N}\}$ consists of all bit indexes $Q_i^{N_{max}}$ in a sequence $\mathbf{Q}_0^{N_{max}-1} = \{Q_0^{N_{max}}, Q_1^{N_{max}}, ..., Q_{N_{max}-1}^{N_{max}}\}$ that are less than $N = 2^n (n \le 10)$, i.e., the polar sequence $\mathbf{Q}_0^{N-1} = \{Q_0^{N}, Q_1^{N}, Q_2^{N}, ..., Q_{N-1}^{N}\}$ is a subset of the sequence $\mathbf{Q}_0^{N_{max}-1} = \{Q_0^{N_{max}}, Q_1^{N_{max}}, ..., Q_{N_{max}-1}^{N_{max}}\}$. The elements in the polar sequence $\mathbf{Q}_0^{N-1} = \{Q_0^{N}, Q_1^{N}, Q_2^{N}, ..., Q_{N-1}^{N}\}$ are sorted in ascending order according to reliability, i.e., $W(Q_0^{N}) < W(Q_1^{N}) < ... < W(Q_{N-1}^{N})$. An information bit index set $\mathbf{Q}_I^{N}$ is a set consisting of some of bit indexes in the polar sequence $\mathbf{Q}_0^{N}$, and a frozen bit index set $\mathbf{Q}_F^{N}$ consists of the remaining bit indexes in the polar sequence $\mathbf{Q}_0^{N-1}$. A size of the information bit index set $\mathbf{Q}_I^{N}$ is $|\mathbf{Q}_I^{N}| = K$, and a size of the set $\mathbf{Q}_F^{N}$ is $|\mathbf{Q}_F^{N}| = N - K$. Specifically, the information bit index set $\mathbf{Q}_I^{N}$ consists of K most reliable bit indexes in $\mathbf{Q}_0^{N-1}$, and meanwhile, there is a frozen bit index set $\mathbf{Q}_F^{N} = \mathbf{Q}_0^{N-1} \backslash \mathbf{Q}_I^{N}$. It should be understood that in the present disclosure, the symbol "\" represents the difference, and for example, A\B represents: taking data in A other than B, and for example, $\mathbf{Q}_F^{N} = \mathbf{Q}_0^{N-1} \backslash \mathbf{Q}_I^{N}$ represents taking data in $\mathbf{Q}_0^{N-1}$ other than $\mathbf{Q}_I^{N}$.

In another possible implementation, the polar sequence may be obtained according to a preset algorithm.

The preset algorithm may include, but is not limited to, a Gaussian approximation (GA) algorithm, a density evolution algorithm, a PW sequence algorithm, or a reinforcement learning algorithm, or may be other algorithms that emerge as standards evolve. Specifically, the process of obtaining the polar sequence according to any one of the GA algorithm, density evolution algorithm, PW sequence algorithm, or reinforcement learning algorithm, may refer to the prior art.

Taking the polar sequence obtained according to the GA algorithm as an example, the polar sequence $\mathbf{Q}_0^{N-1} = \{Q_0^{N}, Q_1^{N}, Q_2^{N}, ..., Q_{N-1}^{N}\}$ is sorted in descending order according to a value of a polar channel error probability $P_e(W_N^{(Q_i^N)})$, that is, $P_e(W_N^{(Q_0^N)}) > P_e(W_N^{(Q_1^N)}) > ... > P_e(W_N^{(Q_{N-1}^N)})$, $P_e(W_N^{(Q_i^N)})$ is calculated as shown in the following Formula (1):

$$P_e\left(W_{N_{max}}^{(j)}\right) = Q\left(\frac{m_n^{(j)}}{\sqrt{2m_n^{(j)}}}\right) = Q\left(\sqrt{\frac{m_n^{(j)}}{2}}\right), \text{ Formula (1)}$$

Where $Q(\varsigma) = \frac{1}{\sqrt{2\pi}} \int_{\varsigma}^{+\infty} e^{-\frac{z^2}{2}} dz$ and $m_n^{(i)}$ is a mean value of log-likelihood, and $n = \log_2 N$. The calculation method of $m_n^{(i)}$ is shown in the following Formula (2):

$$m_{i+1}^{(2j-1)} = f_c\left(m_i^{(j)}\right), m_{i+1}^{(2j)} = f_v\left(m_i^{(j)}\right), \text{ Formula (2)}.$$

The functions $f_c(t)$ and $f_v(t)$ are defined as follows:

$$f_c(t) = \phi^{-1}\left(1 - \left(1 - \phi(t)\right)^2\right),$$

$$f_v(t) = 2t$$

where a representation mode of the function $\phi(t)$ is shown in the following Formula (3):

$$\begin{cases} 1 - \dfrac{1}{\sqrt{4\pi t}} \int_{\mathbb{R}} \tanh\left(\dfrac{z}{2}\right) e^{-\frac{(z-t)^2}{4t}}\, dz & t > 0, \\ 1 & t = 0 \end{cases} \quad \text{, Formula (3)}$$

and $m_0^{(1)} = \dfrac{2}{\sigma^2}$ , where $m_0^{(1)} = \sigma^2$ is a noise variance to a binary-input Gaussian white noise channel.

Exemplarily, the bit indexes included in the polar sequence may be sorted in index order to obtain a bit index sequence, and the obtained bit index sequence is divided to obtain a plurality of subcodes, each of the subcodes has a length of an integer power of 2, and the length of the subcode may be set according to requirements. In the present disclosure, the bit index sequence may be divided at equal intervals, or the bit index sequence may be divided at unequal intervals, which is not limited thereto. The present disclosure takes equal intervals as an example for explanations, and the case of being divided at unequal intervals may be referred to the methods described in the present disclosure, which will not be repeated.

Take the polar sequence $\mathbf{Q}_0^{\,\cdot\,\cdot} = \{Q_0^{\cdot}, Q_1^{\cdot}, Q_2^{\cdot}, \ldots, Q_{N-1}^{\cdot}\}$ including N bit indexes as an example, for this polar sequence, the bit index sequence obtained by sorting in natural order from small to large according to the index values is $\mathbf{Q}_0^{\,\prime\nu-1} = \{0,1,2,\ldots,N-1\}$ , and taking a segment length of the equal interval as $M=2^m(m<10)$, $\mathbf{Q}_0^{\,\prime\nu-1} = \{0,1,2,\ldots,N-1\}$ is segmented at equal intervals to obtain $T = N / M = 2^{n-m}$ subcodes, and a length of each subcode is $M=2^m(m<10)$.

S202, traverse each subcode of the plurality of subcodes to determine whether the subcode supports to be decoded by a preset decoding algorithm, and if it supports to be decoded by the preset decoding algorithm, determine whether a next subcode supports to be decoded by the decoding algorithm; if it does not support to be decoded by the preset decoding algorithm, perform S203.

The preset decoding algorithm may include but is not limited to any one of the following Fast-SC algorithms: Rate-0, repetition (Repetition, REP), REP-2, parity checked repetition (Parity checked repetition, PCR), repeated parity check (Repeated parity check, RPC), SPC-2, single-parity-check (Single-Parity-Check, SPC) and Rate-1, and the preset decoding algorithm may also be other decoding algorithms that emerge as standards evolve, which are not limited herein.

Exemplarily, each subcode may be traversed in order from small to large according to a serial number of a segment in which the subcode is located, to determine whether the subcode supports to be decoded by the preset decoding algorithm. For example, if the bit index sequence is divided into T subcodes, serial numbers of segments in which these T subcodes are located are sorted from small to large as 0, 1, 2 to T-1, and then, starting from a subcode with a serial number 0, whether the subcode supports to be decoded by the preset decoding algorithm may be determined, if it supports, it is to be determined whether a subcode with a serial number 1 supports to be decoded by the preset decoding algorithm, and if it does not support, S203 is performed; and when the subcode is adjusted to support to be decoded by the preset decoding algorithm, it is to be determined whether a subcode with a serial number 2 supports to be decoded by the preset decoding algorithm, and so on, until it is to be determined whether a subcode with a serial number T-1 supports to be decoded by the preset decoding algorithm, if it supports, the process ends, and if it does not support, S203 is performed, the information bit index included in the subcode is adjusted to that the subcode supports to be decoded by the preset decoding algorithm, and then the process ends.

In a possible implementation, whether the subcode is decoded by the preset decoding algorithm may be determined according to the number of information bit indexes included in the subcode. Specifically, the number of information bit indexes corresponding to the subcode that supports to be decoded by the preset decoding algorithm may be stored in a set, and the set may be referred to as a third number set or a fast decoding set, the naming of which is not limited, and in the present disclosure, the third number set is taken as an example for explanations. Furthermore, it is to be determined whether the number of information bit indexes included in the subcode is included in the third number set, and if it is not included, it is determined that the subcode does not support to be decoded by the preset decoding algorithm, and if it is included, it is determined that the subcode supports to be decoded by the preset decoding algorithm.

For example, the information bit index set of the polar sequence $\mathbf{Q}_0^{N-1} = \{Q_0^N, Q_1^N, Q_2^N, ..., Q_{N-1}^N\}$ is $\mathbf{Q}_I^N$, The bit index sequence $\mathbf{Q}_0^{N-1} = \{0,1,2,...,N-1\}$ corresponding to $\mathbf{Q}_0^N = \{Q_0^N, Q_1^N, Q_2^N, ..., Q_{N-1}^N\}$ is segmented at equal intervals to obtain $T = N / M = 2^{n-m}$ subcodes, and for a $t$-th subcode, the bit index set of this subcode is $\mathbf{P}_t = \{t \times M, t \times M+1, t \times M+2,..., t \times M+(M-1)\}$, where $0 \leq t \leq T - 1$. When detecting the $t$-th subcode, bit indexes belonging to the information bit set $\mathbf{Q}_I^N$ in $\mathbf{P}_t$ of the $t$-th subcode are counted first, to obtain the number $k_t = \left| P_t \cap \mathbf{Q}_I^N \right|$ of information bit indexes and the number $f_t = M - k_t$ of frozen bit indexes included in the $t$-th subcode, and then, determine whether $k_t$ belongs to the third number set $\mathbf{S}$, and if the number $k_t$ of information bit indexes included in the $t$-th subcode belongs to the third number set $\mathbf{S}$, it is determined that the $t$-th subcode can be decoded by the preset decoding algorithm; otherwise, it is determined that the $t$-th subcode does not support to be decoded by the preset decoding algorithm.

The third number set includes a plurality of data, and the data is the number of information bit indexes included in the subcode that supports to be decoded by the preset decoding algorithm. The length of the subcode that supports to be decoded by the preset decoding algorithm is the same as the length of the subcode obtained by segmenting, and the subcode that supports to be decoded by the preset decoding algorithm may be pre-specified or specified by a protocol. For example, taking the code length M as an example, the third number set is a subset of $\Omega = \{0,1,2,..., M - 1\}$.

For example, taking the preset decoding algorithm as the Fast-SC algorithm as an example, subcodes supported by the Fast-SC algorithm may include the following eight types: Rate-0, Repetition (REP), REP-2, Parity checked repetition (PCR), Repeated parity check (RPC), SPC-2, Single-Parity-Check (SPC), and Rate-1, and code rates corresponding to these subcodes are 0, 1/16, 2/16, 3/16, 13/16, 14/16, 15/16, and 1, respectively, and in addition, two types of subcodes with code rates of 7/16 and 11/16 may also support to be decoded by the Fast-SC algorithm, code lengths of these ten types of subcodes are a positive integer power of 16, and taking the code length of these ten types of subcodes as 16 as an example, the numbers of information bit indexes included in these ten types of subcodes are 0, 1, 2, 3, 13, 14, 15, 16, 7, and 11, respectively, the numbers of information bit indexes of these ten types of subcodes are stored in the set {0, 1, 2, 3, 13, 14, 15, 16, 7, 11}, and this set may be used to determine whether the subcode obtained by segmenting supports to be decoded by the Fast-SC algorithm. For example, if a code length of a subcode is 16 and the number of information bit indexes 3 belongs to this set, it is determined that the subcode supports to be decoded by the Fast-SC algorithm; if the number 8 of information bit indexes included in the subcode does not belong to this set, it is determined that the subcode does not support to be decoded by the Fast-SC algorithm.

It should be understood that, with reference to the above-mentioned implementations, alternatively, the number of information bit indexes corresponding to the subcode that do not support to be decoded by the preset decoding algorithm may be stored in a set (which may be referred to as a set that does not support to be decoded by the preset decoding algorithm), and the set that does not support to be decoded by the preset decoding algorithm is $\overline{\mathbf{S}} = \Omega \setminus \mathbf{S}$. Furthermore, it is to be determined whether the number of information bit indexes included in a subcode is included in the set; if it is not included, it is determined that the subcode supports to be decoded by the preset decoding algorithm; if it is included, it is determined that the subcode does not support to be decoded by the preset decoding algorithm. For example, taking the the preset decoding algorithm as the Fast-SC algorithm as an example, subcodes that do not support to be decoded by the Fast-SC algorithm include 7 types of subcodes with code rates of 4/16, 5/16, 6/16, 8/16, 9/16, 10/16, and 12/16, and taking the code length of these 7 types of subcodes as 16 as an example, the numbers of information bit indexes of these 7 types of subcodes are stored in a set {4, 5, 6, 8, 9, 10, 12}, and this set may be used to determine whether a subcode obtained by segmenting supports to be decoded by the Fast-SC algorithm. For example, if the code length of a subcode is 16 and the number 4 of information bit indexes thereof belongs to this set, it is determined that the subcode does not support to be decoded by the Fast-SC algorithm; if the number 3 of information bit indexes does not belong to this set $\overline{\mathbf{S}}$, it is determined that the subcode supports to be decoded by the Fast-SC algorithm.

In another possible implementation, it may be determined whether a subcode is decoded by the preset decoding algorithm according to a subcode pattern. If an information bit index combination included in the subcode belongs to the subcode pattern, it is determined that the subcode supports to be decoded by the preset decoding algorithm, and conversely, if the information bit index combination included in the subcode does not belong to the subcode pattern, it is determined that the subcode does not support to be decoded by the preset decoding algorithm.

The subcode pattern may indicate a bit index combination of a subcode that supports to be decoded by the preset decoding algorithm. The subcode pattern may be composed of a plurality of information bit index combinations of subcodes that support to be decoded by the preset decoding algorithm. It should be understood that the present disclosure does not limit the naming of the subcode pattern, which may also be named as a fast decoding pattern set or other names, etc., which is not limited thereto. In addition, the information bit index combination described in the present disclosure is empty or includes at least one information bit, and the information bit index combination corresponding to a subcode is combined by all information bit indexes included in the subcode. In the present disclosure, the subcode pattern may be preset, and for example, it may be pre-specified in a standard. Or, the subcode pattern may be determined according to the reliability of the information bit indexes and/or the type of the subcode that supports to be decoded by the preset decoding algorithm. For example, for a subcode, if the number of information bit indexes required when the subcode supports to be decoded by the preset decoding algorithm is K1, or K2, or K3, K1 bit indexes with the highest reliability may be combined as a bit index combination 1, K2 bit indexes with the highest bit index reliability may be combined as a bit index combination 2, and K3 bit indexes with the highest reliability may be combined as a bit index combination 3, and then the bit index combination 1, bit index combination 2, and bit index combination 3 may be collected to obtain the subcode pattern.

For example, for a t-th subcode $P_t$ with a code length M, if the subcode $P_t$ supports to be decoded by the Fast-SC algorithm, the subcode $P_t$ needs to meet any one of the following eight code rates: 0, 1/16, 2/16, 3/16, 13/16, 14/16, 15/16, and 1; the number of information bit indexes of the subcode $P_t$ needs to meet any one of the following: 0, 1, 2, 3, 13, 14, 15, or 16. Therefore, 0 bit index with the highest reliability, 1 bit index with the highest reliability, 2 bit indexes with the highest reliability, 3 bit indexes with the highest reliability, 13 bit indexes with the highest reliability, 14 bit indexes with the highest reliability, 15 bit indexes with the highest reliability, and 16 bit indexes with the highest reliability may be taken from the subcode $P_t$ respectively, to obtain a subcode pattern **E** shown in Table 1 below; the subcode pattern **E** contains eight combinations. If an information bit index combination included in the t-th subcode belongs to the subcode pattern **E** and is the same as a certain information bit combination in the subcode pattern **E**, it is determined that the t-th subcode supports to be decoded by the preset decoding algorithm; otherwise, it is determined that the t-th subcode does not support to be decoded by the preset decoding algorithm.

Table 1

| $\varnothing$ |
|---|
| $\{t \times M + (M - 1)\}$ |
| $\{t \times M + (M - 2),\ t \times M + (M - 1)\}$ |
| $\{t \times M + (M - 3),\ t \times M + (M - 2),\ t \times M + (M - 1)\}$ |
| $P_t \setminus \{t \times M, t \times M + 1, t \times M + 2\}$ |
| $P_t \setminus \{t \times M, t \times M + 1\}$ |
| $P_t \setminus \{t \times M\}$ |
| $P_t$ |

It should be understood that S201 and S202 are optional steps, which include but is not limited to being performed by the encoding apparatus, and may also be performed by other functional modules or devices, where the encoding apparatus acquires execution results from the other functional modules or devices.

S203, adjust a first subcode that does not support to be decoded by the preset decoding algorithm in the polar sequence, and a number of information bit indexes of the first subcode, based on a target adjustment direction.

The target adjustment direction may include increasing the number of information bit indexes of the first subcode or decreasing the number of information bit indexes of the first subcode. It should be understood that increasing the number of information bit indexes of the first subcode may also be alternatively described as increasing a code rate of the first subcode. Decreasing the number of information bit indexes of the first subcode may also be alternatively described as decreasing the code rate of the first subcode. It should be understood that when adjusting the number of information bit indexes of the first subcode, the code length of the first subcode remains unchanged, so as to ensure that the adjustment of the code rate of the first subcode is implemented by adjusting the number of information bit indexes of the first subcode, and to ensure that the adjusted code rate of the first subcode meets a code rate supported by the preset decoding algorithm.

In a possible implementation, the target adjustment direction may be determined according to a current code rate of the first subcode. For example, if the current code rate of the first subcode is less than a first code rate threshold, it means that the current code rate of the first subcode is small, and in this case, the number of information bit indexes included in the first subcode is determined to be reduced; in this way, in a case where the code rate supported by the preset decoding algorithm is small (for example, the code rate is 3/16), it is enabled that the code rate of the first subcode meets the code rate supported by the preset decoding algorithm as quickly as possible. If the current code rate of the first subcode is greater than a second code rate threshold, it means that the current code rate of the first subcode is large, and in this case, the number of information bit indexes included in the first subcode is determined to be increased; in this way, in a case where the code rate supported by the preset decoding algorithm is large (for example, the code rate is 15/16), it is enabled that the code rate of the first subcode meets the code rate supported by the preset decoding algorithm as quickly as possible.

The first code rate threshold and the second code rate threshold may be set according to requirements, and both may be the same or may be different, which is not limited herein. Exemplarily, the first code rate threshold and the second code rate threshold may both be set as 0.5. For example, if the number of information bit indexes of the subcode is $k_t$, the code rate thereof is $r = k_t / M$, and if $r < 0.5$, the number $k_t$ of information bit indexes of the subcode is decreased, and conversely, the total number $k_t$ of information bit indexes of the subcode is increased.

In another possible implementation, the target adjustment direction may be determined according to a preset set. The preset set includes a first number set; or the preset set includes a second number set; or the preset set includes a first number set and a second number set. The first number set indicates a number of information bit indexes currently included in a subcode with information bit indexes to be increased. The second number set indicates a number of information bit indexes currently included in a subcode with information bit indexes to be decreased.

Taking the preset set including the first number set as an example, in a case where the number of information bit indexes included in the first subcode belongs to the first number set, the target adjustment direction is to increase the number of information bit indexes of the first subcode. In a case where the number of information bit indexes included in the first subcode does not belong to the first number set, the target adjustment direction is to decrease the number of information bit indexes of the first subcode.

Taking the preset set including the second number set as an example, in a case where the number of information bit indexes included in the first subcode does not belong to the second number set, the target adjustment direction is to increase the number of information bit indexes of the first subcode. In a case where the number of information bit indexes included in the first subcode belongs to the second number set, the target adjustment direction is to decrease the number of information bit indexes included in the first subcode.

Taking the preset set including the first number set and the second number set as an example, in a case where the information bit indexes included in the first subcode belong to the first number set, the target adjustment direction is to increase the number of information bit indexes of the first subcode. In a case where a set of information bit indexes included in the first subcode belongs to the second number set, the target adjustment direction is to decrease the number of information bit indexes of the first subcode.

It should be understood that the present disclosure does not limit the naming of the first number set and the second number set; alternatively, the first number set may also be named as a rate-increasing segment information bit number set $\mathbf{S}_{sup}$ or a code rate-increasing segment information bit number set. The second number set may also be named as rate-decreasing segment information bit number set $\mathbf{S}_{sub}$ or a code rate-decreasing segment information bit number set.

For example, taking the preset set including the rate-increasing segment information bit number set $\mathbf{S}_{sup}$ = {6,9,10,12} and the rate-decreasing segment information bit number set $\mathbf{S}_{sub}$ = {4,5,8} as an example, if the number of information bit indexes of the first subcode is $k_3 = 6 \in \mathbf{S}_{sup}$, since the number of information bit indexes is $k_3 = 6 \in S_{sup}$, the number $k_3$ of information bit indexes in the first subcode is determined to be increased.

In the present disclosure, for the first subcode with the number of information bit indexes to be adjusted, the number of information bit indexes included in the first subcode may be iteratively adjusted in the following mode, until the adjusted first subcode supports to be decoded by the preset decoding algorithm: according to the target adjustment direction, acquiring a to-be-adjusted bit index in the first subcode; selecting a target bit index from a candidate index sequence other than the first subcode; and adjusting index types of the to-be-adjusted bit index and the target bit index.

The candidate index sequence includes d bit indexes with an index type different from an index type of the to-be-adjusted bit index and with reliability closest to reliability of the to-be-adjusted bit index, among bit indexes other than the first subcode. d is a preset number and may be set according to requirements. For example, d may be set as 3 or other values. In this way, the matched target bit index may be selected from the candidate index sequence other than the first subcode, and since the candidate index sequence may include segments after a segment in which the first subcode is located, and may also include segments before the segment in which the first subcode is located, the candidate index sequence provided in the present disclosure may expand the selecting range of the target index bit, which is no longer limited to using frozen bit indexes after the segment in which the first subcode is located as the selecting range, so as to find the matched target bit index from the candidate index sequence more efficiently and accurately.

The index types include two types: an information bit index and a frozen bit index. Adjusting the index types of the to-be-adjusted bit index and the target bit index may also be described as exchanging the index types of the to-be-adjusted bit index and the target bit index. For example, if the to-be-adjusted bit index is the information bit index and the target bit index is the frozen bit index, the to-be-adjusted bit index is adjusted from the information bit index to the frozen bit index, and the index type of the target bit index is adjusted from the frozen bit index to the information bit index. Alternatively, if the to-be-adjusted bit index is the frozen bit index and the target bit index is the information bit index, the to-be-adjusted bit index is adjusted from the frozen bit index to the information bit index, and the target bit index is adjusted from the information bit index to the frozen bit index.

The to-be-adjusted bit index may refer to a bit index with the index type to be adjusted in the first subcode. It should be understood that the present disclosure does not limit the naming of the to-be-adjusted bit index, and it may also be alternatively described as a to-be-exchanged bit index. Specifically, acquiring the to-be-adjusted bit index in the first subcode according to the target adjustment direction, may include: in a case where the target adjustment direction is to increase the number of information bit indexes included in the first subcode, acquiring a frozen bit index in the first subcode as the to-be-adjusted bit index, and increasing the number of information bit indexes in the first subcode. In a case where the target adjustment direction is to decrease the number of information bit indexes included in the first subcode, acquiring an information bit index in the first subcode as the to-be-adjusted bit index, which enables to reduce the number of information bit indexes in the first subcode.

In a possible implementation, in a case where the target adjustment direction is to increase the number of information bit indexes included in the first subcode, the to-be-adjusted bit index is a frozen bit index with reliability greater than a first reliability threshold in the first subcode. The first reliability threshold may be set according to requirements. Optionally, in the process of the iterative adjustment, when the adjustment is performed for the first time, the to-be-adjusted bit index is a frozen bit index with the highest reliability, and when the adjustment is performed for the second time, the to-be-adjusted bit index may be a frozen bit index with the second highest reliability, and so on. As mentioned above, the information bit indexes and frozen bit indexes are obtained by dividing in order from high to low reliability, and correspondingly, the candidate index sequence includes d information bit indexes with lowest reliability, among information bit indexes other than the first subcode in the polar sequence, and the reliability of these d information bit indexes with the lowest reliability is closest to that of frozen bit indexes with highest reliability in the first subcode. In this way, in a case where the index type of the frozen bit index with the highest reliability in the first subcode is replaced with that of a certain information bit index among the d information bit indexes with the lowest reliability, it is ensured that the information bits are still transmitted on the polar channel with a good channel capacity, which does not affect the transmission performance of the communication system, and may also ensure that the encoded sequence after encoding is decoded by the preset decoding algorithm, thereby improving the decoding performance.

For example, if the number $k_t$ of information bit indexes of the first subcode needs to be increased, a frozen bit index with the highest reliability in the first subcode is denoted as a to-be-adjusted bit index $i$. Information bit indexes in all segments other than the first subcode are sorted in ascending order according to reliability, to obtain an external information bit index sequence $\mathbf{D}_I = \{D_0, D_1, D_2, ..., D_{K-k_t-1}\}$, the first d information bit indexes are selected from the sequence $\mathbf{D}_I$ as the candidate index sequence, and the target bit index $J$ is selected from the candidate index sequence.

In another possible implementation, in a case where the target adjustment direction is to decrease the number of information bit indexes included in the first subcode, the to-be-adjusted bit index is an information bit index with reliability less than a second reliability threshold in the first subcode, where the second reliability threshold may be set according to requirements. Optionally, in the process of the iterative adjustment, when the adjustment is performed for the first time, the to-be-adjusted bit index is an information bit index with the lowest reliability, and when the adjustment is performed for the second time, the to-be-adjusted bit index may be an information bit index with the second lowest reliability. As mentioned above, the information bit indexes and the frozen bit indexes are obtained by dividing in order from high to low reliability, and correspondingly, the candidate index sequence includes d frozen bit indexes with the highest reliability among frozen bit indexes in the polar sequence other than the first subcode, and the reliability of these d information bit indexes with the highest reliability is closest to that of the frozen bit indexes with the lowest reliability in the first subcode. In this way, in a case where the index type of the information bit index with the lowest reliability in the first subcode is replaced with that of a certain frozen bit index among the d frozen bit indexes with the highest reliability, it is ensured that the information bits are still transmitted in the polar channel with a good channel capacity, which does not affect the transmission performance of the communication system, and may also ensure that the encoded sequence after encoding is decoded by the preset decoding algorithm, thereby improving the decoding performance.

For example, if it is necessary to decrease the number $k_t$ of information bit indexes in the first subcode, an information bit index with the lowest reliability in the first subcode is denoted as a to-be-adjusted bit index $i$, frozen bit indexes in all segments other than the first subcode are sorted in descending order according to reliability, to obtain an external frozen bit index sequence $\mathbf{D}_F = \{D_0, D_1, D_2, ..., D_{N-K-f_t-1}\}$, the first d frozen bit indexes are select from the sequence $\mathbf{D}_F$ as the candidate index sequence, and a target bit index $j$ is selected from the candidate index sequence.

In the present disclosure, the target bit index may be a bit index in the candidate index sequence, that is in a second subcode which does not support to be decoded by the preset decoding algorithm; or, the target bit index may be a bit index in the candidate index sequence, that is in a third subcode which supports to be decoded by the preset decoding algorithm, where the third subcode supports to be decoded by the preset decoding algorithm both before and after the index type of the target bit index is adjusted.

Specifically, selecting the target bit index from the candidate index sequence includes the following process:

traversing bit indexes in the candidate index sequence to determine whether there is a bit index in the candidate index sequence that belongs to the second subcode; where the second subcode does not support to be decoded by the preset decoding algorithm; and

in a case where there is a bit index in the candidate index sequence that belongs to the second subcode, using the bit index that belongs to the second subcode as the target bit index. Optionally, in a case where there is one bit index that belongs to the second subcode, the one bit index that belongs to the second subcode may be used as the target bit index. In a case where there are a plurality of bit indexes that belong to the second subcode, a bit index with a small index value among the plurality of bit indexes that belong to the second subcode may be used as the target bit index; in a case where there is no bit index in the candidate index sequence that belongs to the second subcode, traversing bit indexes in the candidate bit indexes; if it is determined that a certain bit index belongs to the third subcode, and the third subcode supports to be decoded by the preset decoding algorithm, comparing an index value of the to-be-adjusted bit index with that of the bit index that belongs to the third subcode; if the index value of the bit index that belongs to the third subcode is greater than the index value of the to-be-adjusted bit index, using the bit index that belongs to the third subcode as the target bit index; and conversely, if the index value of the bit index that belongs to the third subcode is less than the index value of the to-be-adjusted bit index, determining whether the third subcode supports to be decoded by the preset decoding algorithm both before and after the index type of the target bit index is adjusted; and if it supports to be decoded by the preset decoding algorithm before and after the adjustment, using the bit index that belongs to the third subcode as the target bit index.

Whether the bit index in the candidate index sequence belongs to the second subcode or the third subcode may be determined by: determining a segment in which the bit index is located, counting a number of information bit indexes of a subcode corresponding to the segment, and if the number of information bit indexes does not belong to the third number set, determining that the bit index belongs to the second subcode, and conversely, it belongs to the third subcode. Or, referring to the above-mentioned mode of determining according to the subcode pattern, it is to be determined whether an information bit index combination of a subcode corresponding to the segment belongs to the subcode pattern, and if it does not belong to, it is determined that the subcode is the second subcode that does not support to be decoded by the preset decoding algorithm, and the bit index belongs to the second subcode, and conversely, it belongs to the third subcode.

For example, assuming that the preset decoding algorithm is the Fast-SC algorithm, and a set that does not support to be decoded by the Fast-SC algorithm is $\overline{S}$, taking $\mathbf{D}_I$ (or $\mathbf{D}_F$) as an example, the target bit index $j$ may be selected by:

acquiring the first $d$ elements of $\mathbf{D}_I$ or $\mathbf{D}_F$ as the candidate index sequence $\{D_0,D_1,D_2,...,D_{d-1}\}$, and if it is determined that there is a bit index in the candidate index sequence $\{D_0,D_1,D_2,...,D_{d-1}\}$ that belongs to a subcode that cannot be decoded by the Fast-SC algorithm, directly selecting the bit index as the target index $j$. Specifically, segment indexes $\mathbf{T}_D = \{t_e \mid 0 \le e < d\}$ corresponding to the first $d$ bit indexes $\{D_0,D_1,D_2,...,D_{d-1}\}$ are first calculated, where $t_e = \lfloor D_e / M \rfloor$. The number of information bit indexes corresponding to $\mathbf{T}_D$ is $\mathbf{K_{T_D}} = \{k_{t_e} \mid 0 \le e < d\}$, where $k_{t_e} = \left| \mathbf{P}_{t_e} \cap \mathbf{Q}_i^{''} \right|$. If $\mathbf{K_{T_D}} \cap \mathbf{S} \ne \emptyset$, it means that there is a bit index in the first $d$ bit indexes of $\mathbf{D}_I$ or $\mathbf{D}_F$ that cannot be decoded by the Fast-SC algorithm. If there is a bit index $k_{t_e} \subseteq \mathbf{S}$ in $\mathbf{K_{T_D}}$, $D_e$ is directly selected as the target index $j$. If there are a plurality of bit indexes $k_{te} \subseteq S$ in $\mathbf{K_{T_D}}$, an index $D_e$ with a smallest subscript is selected as the target index $j$. If $\mathbf{K_{T_D}} \cap \mathbf{S} = \emptyset$, it means that there is no bit index that cannot be decoded by the Fast-SC algorithm, in the candidate index sequence $\{D_0,D_1,D_2,...,D_{d-1}\}$.

If there is no bit index that cannot be decoded by the Fast-SC algorithm in the candidate index sequence $\{D_0,D_1,D_2,...,D_{d-1}\}$, starting from $D_0$, it is to be determined that whether $D_0$ meets the following requirement: comparing relative values of $D_0$ and the to-be-adjusted bit index $i$, and if $D_0 > i$, $D_0$ is directly selected as the target index $j$. If $D_0 < \overline{i}$ and it may still be decoded by the Fast-SC algorithm after the code rate of the subcode of $D_0$ is adjusted, $D_0$ is directly selected as the target index $j$; otherwise, whether a next bit index $D_1$ meets the requirement is detected in sequence. This detection process is repeated, until the target index $j$ that meets the requirement is obtained.

It should be understood that in the present disclosure, for a plurality of subcodes, segments in which the subcodes are located may be numbered, and the following processing process may be performed on each of the subcodes in sequence according to segment numbers from small to larger: determining whether the subcode (such as the subcode with a smallest segment number) supports to be decoded by the preset decoding algorithm, and if it does not support, adjusting the number of information bit indexes of the subcode according to the process shown in S203, so as to adjust the subcode to support to be decoded by the preset decoding algorithm; if it supports, performing the processing process on a next subcode in sequence, and traversing each subcode until performing the processing process on a last subcode (a subcode with a largest segment number). It should be noted that for the last subcode, there is no next subcode, so when processing the last subcode, if the last subcode does not support to be decoded by the preset decoding algorithm, the number of information bit indexes of the last subcode is adjusted with reference to S203; if it supports, the adjustment of the bit indexes of the polar sequence ends.

It should be noted that the present disclosure is not limited to the example of processing the subcodes according to segment numbers in sequence from small to large for explanations, and alternatively, the subcodes may be processed in sequence according to segment numbers in order from large to small, the processing process of which may refer to the above and will not be repeated.

Furthermore, after adjusting the index types of the to-be-adjusted bit index and the target bit index of the first subcode, the information bit indexes and the frozen bit indexes in the polar sequence change, and in this case, it is also necessary to update the information bit index set and the frozen bit index set corresponding to the polar sequence in real time, to ensure the accuracy of the information bit index set and the frozen bit index set in the polar sequence.

Optionally, updating the information bit index set and the frozen bit index set corresponding to the polar sequence may include: in a case of increasing the number of information bit indexes of the first subcode, deleting the adjusted bit index in the first subcode from the frozen bit index set and updating to the information bit index set, and deleting the target bit index from the information bit index set and updating to the frozen bit index set.

In a case of decreasing the number of information bit indexes in the first subcode, the adjusted bit index in the first subcode is deleted from the information bit index set and updated to the frozen bit index set, and the target index bit is deleted from the frozen bit index and updated to the information bit index set.

For example, assuming that the information bit index set of the polar sequence is $\mathbf{Q}_I^{i,v}$ and the frozen bit index set of the polar sequence is $\mathbf{Q}_F^{i,v}$, after the to-be-adjusted bit index $i$ and the target bit index $j$ are determined, the information bit index set $\mathbf{Q}_I^{i,v}$ and the frozen bit index set $\mathbf{Q}_F^{i,v}$ may be updated by the following method:

if the number $k_t$ of information bit indexes of the current subcode needs to be increased, the updated information bit set is $\mathbf{Q}_I^{i,v} = \{\mathbf{Q}_I^{i,v} \setminus \{j\}\} \cup \{i\}$, i.e., by deleting (or removing) the target bit index $j$ from the information bit index set $\mathbf{Q}_I^{i,v}$, and updating the to-be-adjusted bit index $i$ to the information bit index set $\mathbf{Q}_I^{i,v}$. The updated frozen bit index set is $\mathbf{Q}_F^{i,v} = \{\mathbf{Q}_F^{i,v} \setminus \{i\}\} \cup \{j\}$, i.e., by deleting the to-be-adjusted bit index $i$ from the frozen bit index set $\mathbf{Q}_F^{i,v}$ and updating the target bit index $j$ to the frozen bit index set $\mathbf{Q}_F^{i,v}$.

if the number $k_t$ of information bit indexes in the current subcode needs to be decreased, the updated information bit index set is $\mathbf{Q}_I^{i,v} = \{\mathbf{Q}_I^{i,v} \setminus \{i\}\} \cup \{j\}$, i.e., by deleting the to-be-adjusted bit index $i$ from the information bit index set $\mathbf{Q}_I^{i,v}$, and updating the target bit index $j$ to the information bit index set $\mathbf{Q}_I^{i,v}$. The updated frozen bit index set is $\mathbf{Q}_F^{i,v} = \{\mathbf{Q}_F^{i,v} \setminus \{j\}\} \cup \{i\}$, i.e., by deleting the target bit index $j$ from the frozen bit index set $\mathbf{Q}_F^{i,v}$, and updating the to-be-adjusted bit index $i$ to the frozen bit index set $\mathbf{Q}_F^{i,v}$.

S204: obtain a sequence to be encoded based on the polar sequence that has been adjusted and the input bit sequence.

The polar sequence that has been adjusted may refer to a new polar sequence obtained by traversing the respective subcodes of the polar sequence completely and performing the above-mentioned S202 and S203 on the subcodes. It should be understood that as the to-be-adjusted bit index and the target bit index in the subcode are adjusted, the information bit indexes and the frozen bit indexes in the polar sequence also change, and the index types of some bit indexes will change, but the total number of information bit indexes and the total number of frozen bit indexes in the polar sequence remain unchanged.

In a possible design, S204 is performed in a case where all subcodes in the polar sequence support to be decoded by the preset decoding algorithm. In another possible design, S204 is performed in a case where the number of subcodes in the polar sequence that support to be decoded by the preset decoding algorithm reaches a preset number requirement, which not only ensures the overall transmission performance of the communication system, but also may improve the encoding efficiency.

The input bit sequence may be alternatively described as a valid information bit sequence, input information bits, or other names, which is not limited herein. The input bit sequence includes K input bits, where the input bits may be valid information bits or information bits, and K is equal to a total number of information bit indexes in the polar sequence. Exemplarily, the input bit sequence may be obtained according to a baseband signal generated by a baseband module of the sending end, or may be obtained by processing the baseband signal generated by the baseband module, e.g., obtained by performing modulation or other processing on the baseband signal generated by the baseband module.

Optionally, the modulation mode may include, but is not limited to, any one of the following modulation modes: quadrature amplitude modulation (Quadrature Amplitude Modulation, QAM), absolute phase shift keying (Absolute Phase Shift Keying, APSK) modulation, binary phase shift keying (Binary Phase Shift Keying, BPSK), and quadrature phase shift keying (Quadrature Phase Shift Keying, QPSK) modulation.

Optionally, the length of the to-be-encoded sequence is the same as the length of the polar sequence, and the to-be-encoded sequence includes bits corresponding to bit indexes sorted from small to large.

Specifically, obtaining the to-be-encoded sequence based on the polar sequence that has been adjusted and the input bit sequence, may include: in order of information bits in the input bit sequence, mapping the information bits in sequence to positions in which information bit indexes of the polar sequence that has been adjusted are located, where one/an information bit is mapped to a position in which one/an information bit index is located. Fixed bits, a fixed bit (such as bit "0", etc.) is configured on a position in which the information bit index in the polar sequence that has been adjusted is located.

Assuming that the input bit sequence is represented as $c_0, c_1, c_2, c_3, ..., c_{K-1}$, the length of the polar sequence is N, the number of information bit indexes is K, and the information bit index set of the polar sequence that has been adjusted is $\mathbf{Q}_I^{\prime\prime}$, the to-be-encoded sequence $\mathbf{u} = [u_0, u_1, u_2, ..., u_{N-1}]$ may be obtained in the following mapping mode:

$$k=0;$$
$$\text{for } n = 0 \text{ to } N-1$$
$$\text{if } n \in \mathbf{Q}_I^{\prime\prime}$$
$$u_n = c_k;$$
$$k = k + 1;$$
$$\text{else}$$
$$u_n = 0;$$
$$\text{end if}$$
$$\text{end for.}$$

That is, for K input bits from 0 to K-1, in the order of the input bits, starting from the 0th input bit, they are mapped to bit indexes in the following mode: finding N bit indexes sorted in order from small to large according to index values, traversing each bit index starting from a first bit index, determining whether the bit index belongs to the information bit index set $\mathbf{Q}_I^{\prime\prime}$, and if it belongs to, mapping the 0th input bit to the bit index; and inversely, setting a position in which the bit index is located as 0 (or referred to as padding the position in which the bit index is located with 0). After that, for a first input bit, it is to be found whether a next bit index belongs to an information bit index (i.e., a second information bit index) of the information bit index set $\mathbf{Q}_I^{\prime\prime}$, and if it belongs, the first input bit is mapped to the bit index, and conversely, the position in which the bit index is located is set as (or referred to as filled with) 0, and so on, until a (K-1)th input bit is mapped to a last information bit index, and positions in which other bit indexes (i.e., frozen bit indexes) that do not belong to the information bit index set $\mathbf{Q}_I^{\prime\prime}$ are located are set as 0.

For example, assuming that the polar sequence includes eight bit indexes: 0 to 7, the information bit index set of the polar sequence is {3, 5, 6, 7}, and the frozen bit index set of the polar sequence is {0, 1, 2, 4}, and the input bit sequence is {1, 1, 1, 1}, S204 is performed to map these four input bits to positions in which information bit indexes 3, 5, 6, and 7 are located, respectively, and positions in which frozen bit indexes 0, 1, 2, and 4 are located are padded with fixed bits 0, to obtain a to-be-encoded sequence {0, 0, 0, 1, 0, 1, 1, 1}.

S205, encode the to-be-encoded sequence based on a generated matrix to obtain an encoded sequence, and send the encoded sequence.

The generation matrix is $\mathbf{G}_N = (\mathbf{G}_2)^{\otimes n}$, the generation matrix is an N*N matrix, $\mathbf{G}_N = (\mathbf{G}_2)^{\otimes n}$ represents an n Kronecker product (Kronecker power) of $\mathbf{G}_2$, and $\mathbf{G}_2 = \begin{bmatrix} 1 & 0 \\ 1 & 1 \end{bmatrix}$.

The length and the code rate of the encoded sequence are the same as those of the polar sequence, and the encoded sequence may be referred to as the encoded polar sequence. Optionally, encoding the to-be-encoded sequence based on the generated matrix to obtain the encoded sequence, may include: performing matrix multiplication on the to-be-encoded sequence and the generating matrix to obtain the encoded sequence. For example: the to-be-encoded sequence is $\mathbf{u} = [u_0, u_1, u_2, \ldots, u_{N-1}]$, the encoded sequence is $\mathbf{X} = [x_0, x_1, x_2, \ldots, x_{N-1}]$, and $\mathbf{x} = \mathbf{u}\mathbf{G}_N$.

Optionally, sending the encoded sequence may include: sending the encoded sequence to one or more receiving ends. In the present disclosure, the receiving end may be alternatively described as a transmission node. Specifically, the receiving end may be a decoding apparatus or a device integrated with the decoding apparatus, etc., which is not limited herein.

Correspondingly, the decoding apparatus receives the encoded sequence and decodes the encoded sequence by using the preset decoding algorithm. For example, the Fast-SC algorithm is used to decode the encoded sequence. It should be understood that in a case where the decoding apparatus is integrated into the receiving end, the decoding apparatus receiving the encoded sequence may be alternatively described as that: the receiving end receives the encoded sequence and decodes the encoded sequence by using the encoding apparatus's preset decoding algorithm.

Based on the encoding method shown in FIG. 2, in the embodiments of the present disclosure, for a subcode in the polar sequence that does not support to be decoded by the preset decoding algorithm, the subcode may be adjusted to support to be decoded by the preset decoding algorithm, by increasing the number of information bit indexes of the subcode or decreasing the number of information bit indexes of the subcode, and after the adjustment, the encoding processing is performed to obtain an encoded sequence and send the encoded sequence. In this way, the adjustment direction of the subcode is flexibly designed, and the information bit indexes of the subcode is adjusted adaptively based on the adjustment direction that the subcode is matched with, so that the adjustment direction is no longer fixed simply, which effectively decreases the number of bit indexes that need to be exchanged, and enables that the requirement for the subcode to be decoded by the preset decoding algorithm can be met with fewer adjustments, thereby improving the adjustment efficiency of the subcode, ensuring that all subcodes support to be decoded by the preset decoding algorithm on the basis of the improved adjustment efficiency, and then improving the decoding performance. Meanwhile, in the method shown in the present disclosure, the target bit index is found in d bit indexes with reliability close to reliability of the to-be-adjusted bit index, and index types are exchanged, so that it is remained that information bits are transmitted on the polar channel with high channel quality (or high reliability) both before and after the bit index is adjusted, thereby ensuring the transmission performance of the entire communication system.

For example, Table 2 shows comparisons of exchanging of the number of bit indexes in the method provided in the present disclosure and the method provided in the prior art, in different cases where the code length is 1024 and the total number of information bit indexes is 768, 832, 896, and 960, respectively. As shown in Table 2, in a case where the total number of information bit indexes is 768, in the present disclosure, exchanging bit indexes for 7 times is needed to enable all subcodes support to be decoded by the preset decoding algorithm, while in the method provided in the prior art exchanging bit indexes for 17 times is needed to enable all subcodes to be decoded by the preset decoding algorithm. Similarly, in a case where the total number of information bit indexes is other numbers, the number of times of exchanging bit indexes in the present disclosure is also less than the number of times of exchanging bit indexes in the prior art, and compared with the prior art, the method provided in the present disclosure may effectively reduce the number of bit indexes that need to be exchanged.

Table 2

| N | K | number of times of exchanging bit indexes | |
| --- | --- | --- | --- |
| | | Present disclosure | Prior art |
| 1024 | 768 | 7 | 17 |
| 1024 | 832 | 8 | 10 |
| 1024 | 896 | 5 | 9 |
| 1024 | 960 | 4 | 6 |

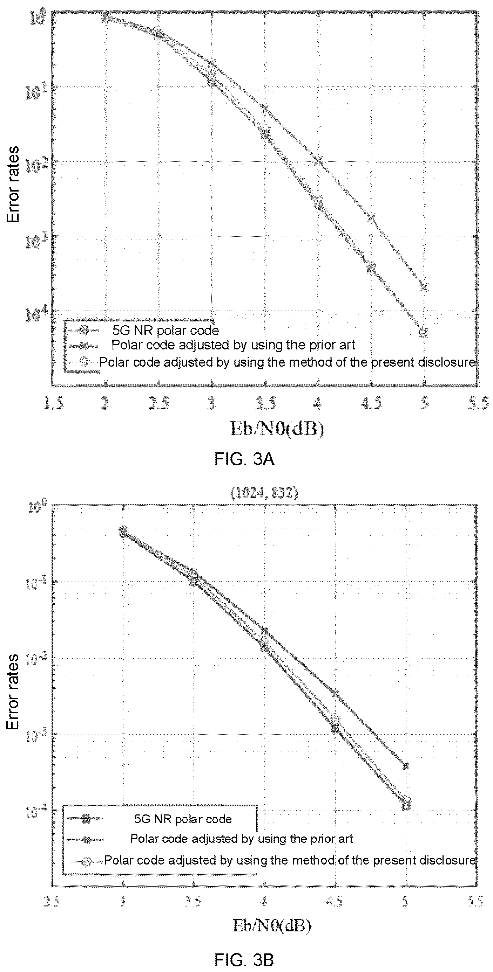

As can be seen from the above, the encoding method provided in the present disclosure may effectively reduce the number of bit indexes that need to be exchanged, thereby improving the performance of the entire communication system. The performance of the encoding scheme provided in the embodiments of the present disclosure is described below in conjunction with FIG. 3A to FIG. 4B.

For example, FIG. 3A shows simulation curve diagrams of an encoding scheme without the adjustment of the code rate, a code rate adjustment scheme in the prior art, and the encoding scheme provided in the embodiments of the present disclosure in the 5G NR communication system, in a communication scenario in which the polar sequence is a polar sequence specified for the 5G NR system (1024, 768), with a code length of 1024, a total number of information bit indexes of 768, an AWGN channel as the polar channel, BPSK as the modulation mode, SC algorithm decoding as the preset decoding algorithm, the third number set **S** = {0,1,2,3,7,11,13,14,15,16 }, and d=3. As shown in FIG. 3A, the horizontal axis is signal-to-noise ratio (signal to noise ratio, SNR) (dB), and the vertical axis is error rates (Error rates), which are all frame error rates shown in FIG. 3A. It can be seen from FIG. 3A that compared with the encoding scheme without the adjustment of the code rate, at a frame error rate of $10^{-3}$, the prior code rate adjustment method causes a performance loss of approximately 0.3 dB, while the encoding method proposed in the present disclosure causes a performance loss of less than 0.05 dB, so compared with the prior code rate adjustment scheme, the performance of the method provided in the present disclosure is greatly improved.

For another example, FIG. 3B shows simulation curve diagrams of an encoding scheme without the adjustment of the code rate, a code rate adjustment scheme in the prior art, and the encoding scheme provided in the embodiments of the present disclosure in the 5G NR communication system, in a communication scenario in which the polar sequence is a polar sequence specified for the 5G NR system (1024, 832), with a code length of 1024, a total number of information bit indexes of 832, an AWGN channel as the polar channel, BPSK as the modulation mode, SC algorithm decoding as the preset decoding algorithm, the third number set **S** = {0,1,2,3,7,11,13,14,15 ,16 }, and d=3. As shown in FIG. 3B, the horizontal axis is signal-to-noise ratio (SNR) (dB), and the vertical axis is Error rates, which are all frame error rates shown in FIG. 3B. It can be seen from FIG. 3B that compared with the encoding scheme without the adjustment of the code rate, at a frame error rate of $10^{-3}$, the prior code rate adjustment method causes a performance loss of approximately 0.3 dB, while the encoding method proposed in the present disclosure causes a performance loss of less than 0.05 dB, so compared with the prior code rate adjustment scheme, the performance of the method provided in the present disclosure is greatly improved.

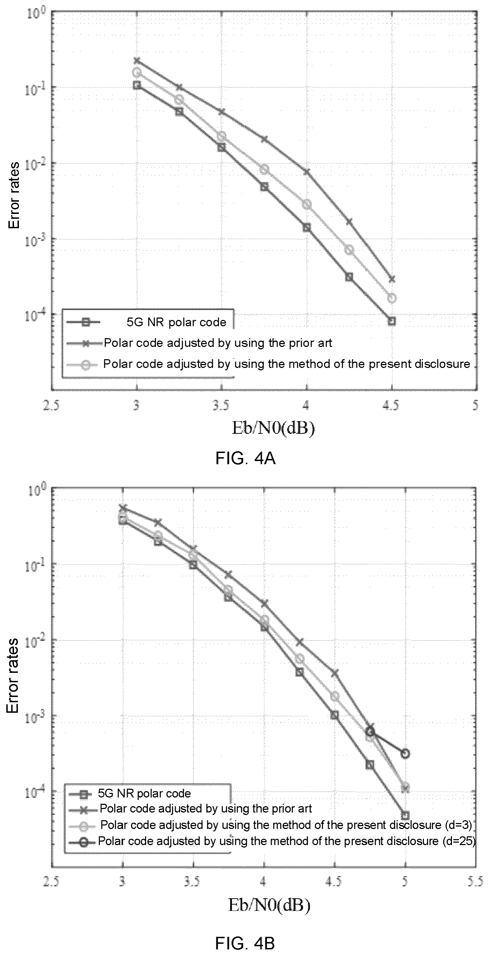

FIG. 3A and FIG. 3B illustrate the performance by taking an example in which the polar sequence is a polar sequence specified for the 5G NR communication systems, and the following illustrates by taking an example in which the polar sequence is a polar sequence obtained according to a GA algorithm, in conjunction with FIG. 4A and FIG. 4B.

For example, FIG. 4A shows simulation curve diagrams of an encoding scheme without the adjustment of the code rate, a code rate adjustment scheme in the prior art, and the encoding scheme provided in the embodiments of the present disclosure in the 5G NR communication system, in a communication scenario in which the polar sequence (1024, 768) is obtained based on the GA algorithm, with a code length of 1024, a total number of information bit indexes of 768, an AWGN channel as the polar channel, BPSK as the modulation mode, SC algorithm decoding as the preset decoding algorithm, the third number set **S** = {0,1,2,3,7,11,13 ,14 ,15 ,16 }, and d=3. As shown in FIG. 4A, the horizontal axis is signal-to-noise ratio (SNR) (dB), and the vertical axis is Error rates, and the curves are all frame error rates in FIG. 4A. It can be seen from FIG. 4A that compared with the encoding scheme without the adjustment of the code rate, at a frame error rate of $10^{-2}$, the prior code rate adjustment method causes a performance loss of approximately 0.3 dB, while the encoding method proposed in the present disclosure causes a performance loss of less than 0.1 dB, so compared with the prior code rate adjustment scheme, the performance of the present disclosure is improved.

For another example, FIG. 4B shows simulation curve diagrams of an encoding scheme without the adjustment of the code rate, a code rate adjustment scheme in the prior art, and the encoding scheme provided in the embodiments of the present disclosure, in a communication scenario in which the polar sequence (1024, 832) is obtained based on the GA algorithm, with a code length of 1024, a total number of information bit indexes of 832, an AWGN channel as the polar channel, BPSK as the modulation mode, SC algorithm decoding as the preset decoding algorithm, the third number set **S** = {0,1,2,3,7,11,13 ,14 ,15 ,16 }, and d=3 or d=25. As shown in FIG. 4B, the horizontal axis is signal-to-noise ratio (SNR) (dB), and the vertical axis is Error rates, and the curves are all frame error rates in FIG. 4B. It can be seen from FIG. 4B that compared with the encoding scheme without the adjustment of the code rate, at a frame error rate of $10^{-2}$, the prior code rate adjustment method causes a performance loss of approximately 0.2 dB, while the encoding method proposed in the present disclosure causes a performance loss of less than 0.1 dB in a case where d=3, so compared with the prior code rate adjustment scheme, the performance of the present disclosure is improved. In a high signal-to-noise ratio area, the performance loss is the same as that caused by the prior code rate adjustment method. In addition, as can be seen from FIG. 4B, in the high signal-to-noise ratio area, the too large parameter $d$ = 25 causes an additional performance loss. Therefore, the parameter d should be selected as a small positive integer, for example, $3 \le d \le 10$.

Assuming that the code length of the polar sequence is N=64, the total number of information bit indexes of the polar sequence is K=8, the preset decoding algorithm is the Fast-SC algorithm, the fast decoding set is **S** = {0,1,2,3,7,11 ,13 ,14 ,15 ,16 }, and the length for segmenting the polar sequence at equal intervals is 16, the method provided in the present disclosure is described in detail below.

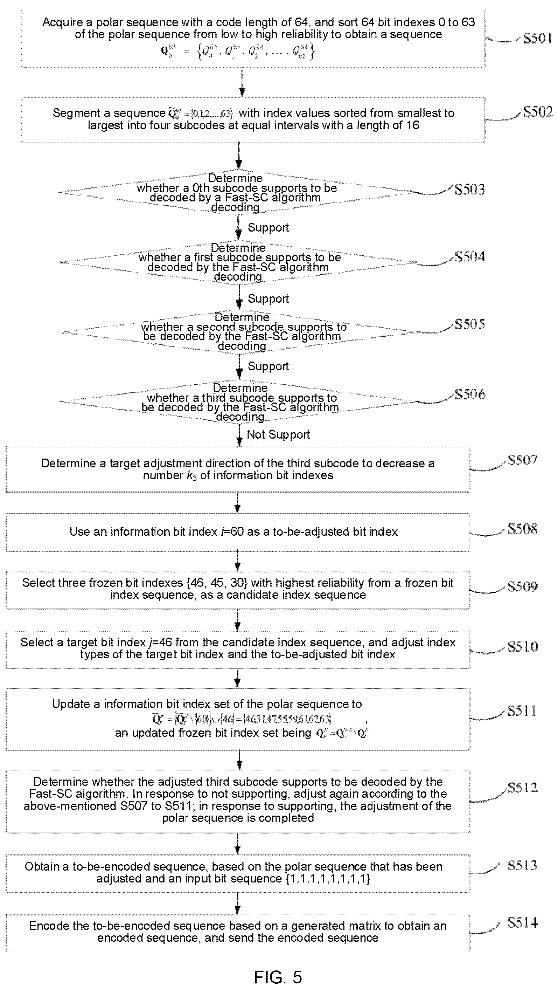

FIG. 5 is a flowchart of another encoding method provided in the present disclosure, as shown in FIG. 5, which includes the following.

S501, acquire a polar sequence with a code length of 64, sort 64 bit indexes 0 to 63 of the polar sequence from low to high reliability to obtain a sequence $Q_0^N = \{Q_0^N, Q_1^N, Q_2^N, \ldots, Q_{63}^N\}$.

The following Table 3 shows the sorting of the reliability $W(Q_i^{64})$ of the 64 bit indexes. Elements in a column of $W(Q_i^{64})$ in Table 3 represent the value of the reliability, and for example, an element 0 in the column of $W(Q_i^{64})$ represents reliability 0, and elements in a column of $Q_i^{64}$ represent bit indexes, and for example, an element 0 in the column of $Q_i^{64}$ represents a bit index 0.

EP 4 683 230 A1

Table 3

| $W(Q_i^{64})$ | $Q_i^{64}$ | $W(Q_i^{64})$ | $Q_i^{64}$ | $W(Q_i^{64})$ | $Q_i^{64}$ | $W(Q_i^{64})$ | $Q_i^{64}$ | $W(Q_i^{64})$ | $Q_i^{64}$ | $W(Q_i^{64})$ | $Q_i^{64}$ | $W(Q_i^{64})$ | $Q_i^{64}$ | $W(Q_i^{64})$ | $Q_i^{64}$ |
|---|---|---|---|---|---|---|---|---|---|---|---|---|---|---|---|
| 0 | 0 | 8 | 5 | 16 | 20 | 24 | 13 | 32 | 22 | 40 | 15 | 48 | 30 | 56 | 60 |
| 1 | 1 | 9 | 9 | 17 | 34 | 25 | 48 | 33 | 38 | 41 | 52 | 49 | 45 | 57 | 31 |
| 2 | 2 | 10 | 6 | 18 | 24 | 26 | 14 | 34 | 41 | 42 | 23 | 50 | 51 | 58 | 47 |
| 3 | 4 | 11 | 17 | 19 | 36 | 27 | 21 | 35 | 28 | 43 | 56 | 51 | 46 | 59 | 55 |
| 4 | 8 | 12 | 10 | 20 | 7 | 28 | 35 | 36 | 42 | 44 | 27 | 52 | 53 | 60 | 59 |
| 5 | 16 | 13 | 18 | 21 | 11 | 29 | 26 | 37 | 49 | 45 | 39 | 53 | 54 | 61 | 61 |
| 6 | 32 | 14 | 12 | 22 | 40 | 30 | 37 | 38 | 44 | 46 | 29 | 54 | 57 | 62 | 62 |
| 7 | 3 | 15 | 33 | 23 | 19 | 31 | 25 | 39 | 50 | 47 | 43 | 55 | 58 | 63 | 63 |

Furthermore, optionally, an information bit index set $\mathbf{Q}_I^{v+} = \{60, 31, 47, 55, 59, 61, 62, 63\}$ is generated by selecting $K = 8$ bit indexes with the highest reliability.

S502, segment at equal intervals with a length M=16, the sequence $\mathbf{Q}_0^{v+} = \{0,1,2,...63\}$ with index values sorted from small to large into $T = 4$ four subcodes: $\mathbf{P}_0 = \{0,1,2,...,15\}$, $\mathbf{P}_1 = \{16,17,18,...,31\}$, $\mathbf{P}_1 = \{16,17,18,...,31\}$, and $\mathbf{P}_3 = \{48,49,50,...,63\}$.

S503, determine whether the 0th subcode supports to be decoded by the Fast-SC algorithm. In a case where the 0th subcode supports to be decoded by the Fast-SC algorithm, S504 is performed.

In an implementation, for the bit index set $\mathbf{P}_0 = \{0,1,2,...,15\}$ of the 0th subcode, a set $\mathbf{P}_0'' = \mathbf{Q}_I^{v+} \cap \mathbf{P}_0$ is calculated to obtain a number $k_0 = |\mathbf{P}_0'| = 0$ of information bit indexes of the 0th subcode. Since $k_0 \in S$, it is determined that the 0th subcode supports to be decoded by the Fast-SC algorithm, and the code rate does not need to be adjusted.

In another implementation, for the bit index set $\mathbf{P}_0 = \{0,1,2,...,15\}$ of the 0th subcode, a set $\mathbf{P}_0' = \mathbf{Q}_I^{v+} \cap \mathbf{P}_0 = \varnothing$ is calculated to obtain an information bit index combination $\mathbf{P}_0'' \subseteq \mathbf{E}$ of the 0th subcode, and it is determined that the 0th subcode supports to be decoded by the Fast-SC algorithm, and the code rate does not need to be adjusted.

S504, determine whether the first subcode supports to be decoded by the Fast-SC algorithm. In a case where the first subcode supports to be decoded by the Fast-SC algorithm, S505 is performed.

In an implementation, for the bit index set $\mathbf{P}_1 = \{16,17,18,...,31\}$ of the first subcode, a set $\mathbf{P}_1' = \mathbf{Q}_I^{v+} \cap \mathbf{P}_1 = \{31\}$ is calculated to obtain a number $k_1 = |\mathbf{P}_1'| = 1$ of information bit indexes of the first subcode, and since $k_1 \in \mathbf{S}$, it is determined that the first subcode supports to be decoded by the Fast-SC algorithm, and the code rate does not need to be adjusted.

In another implementation, for the bit index set $P_1 = \{16,17,18,...,31\}$ of the first subcode, a set $\mathbf{P}_1' = \mathbf{Q}_I^{v+} \cap \mathbf{P}_1 = \{31\}$ is calculated to obtain an information bit index combination $\mathbf{P}_1' = \{31\} = \{1 \times 16 + (16-1)\}$ of the first subcode, and $\mathbf{P}_1' \subseteq \mathbf{E}$, then it is determined that the first subcode supports to be decoded by the Fast-SC algorithm, and the code rate does not need to be adjusted.

S505, determine whether the second subcode supports to be decoded by the Fast-SC algorithm. In a case where the second subcode supports to be decoded by the Fast-SC algorithm, S506 is performed.

In an implementation, for the bit index set $\mathbf{P}_2 = \{32,33,34,...,47\}$ of the second subcode, a set $\mathbf{P}_2' = \mathbf{Q}_I^{v+} \cap \mathbf{P}_2 = \{47\}$ is calculated to obtain a number $k_2 = |\mathbf{P}_2'| = 1$ of information bit indexes of the second subcode, and since $k_2 \in \mathbf{S}$, it is determined that the second subcode supports to be decoded by the Fast-SC algorithm, and the code rate does not need to be adjusted.

In another implementation, for the bit index set $\mathbf{P}_2 = \{32,33,34,...,47\}$ of the second subcode, a set $\mathbf{P}_2' = \mathbf{Q}_I^{v+} \cap \mathbf{P}_2 = \{47\}$ is calculated to obtain an information bit index combination $\mathbf{P}_2' = \{47\} = \{2 \times 16 + \{16-1\}\}$ of the second subcode, and $\mathbf{P}_2' \subseteq \mathbf{E}$, then it is determined that the second subcode supports to be decoded by the Fast-SC algorithm, and the code rate does not need to be adjusted.

S506, determine whether the third subcode supports to be decoded by the Fast-SC algorithm. In a case where the third subcode does not support to be decoded by the Fast-SC algorithm, S507 is performed.

In an implementation, for the bit index set $\mathbf{P}_3 = \{48,49,50,...,63\}$ of the third subcode, a set $\mathbf{P}_3' = \mathbf{Q}_I^{v+} \cap \mathbf{P}_3 = \{55,59,60,61,62,63\}$ is calculated to obtain a number $k_3 = |\mathbf{P}_3'| = 6$ of information bit indexes of the third subcode, and since $k_3 \notin \mathbf{S}$, it is determined that the third subcode does not support to be decoded by the Fast-SC algorithm, and the code rate needs to be adjusted.

In another implementation, for the bit index set $\mathbf{P}_3 = \{48,49,50,...,63\}$ of the third subcode, a set $\mathbf{P}_3' = \mathbf{Q}_I^{v+} \cap \mathbf{P}_3 = \{55,59,60,61,62,63\}$ is calculated to obtain an information bit index combination {55, 59, 60, 61, 62, 63} of the third subcode, which does not belong to a subcode pattern $\mathbf{E}$ shown in Table 4 below, and then it is determined that the third subcode does not support to be decoded by the Fast-SC algorithm, and the code rate needs to be adjusted.

Table 4

| Ø |
|---|
| {63 } |
| {62 , 63 } |
| {61 ,62 ,63 } |
| $\mathbf{P}_3 \setminus \{48,49,50\}$ |
| $\mathbf{P}_3 \setminus \{48,49\}$ |
| $\mathbf{P}_3 \setminus \{48\}$ |
| $\mathbf{P}_3$ |

S507, determine that a target adjustment direction of the third subcode is to decrease the number $k_3$ of information bit indexes.

Assuming that a first code rate threshold is 0.5, since the code rate of the third subcode is $r = k_3/M=3/8<1/2$, it is determined that the target adjustment direction of the third subcode is to decrease the number $k_3$ of information bit indexes.

S508, sort the information bit indexes $\mathbf{P}_3^{\star}$ in the third subcode in ascending order according to reliability to obtain an index sequence {60 ,55 ,59 ,61 ,62 ,63 }, obtain an information bit index $i = 60$ with lowest reliability, and use the information bit index $i = 60$ as a to-be-adjusted bit index.

S509: sort frozen bit indexes in all segments other than the third subcode in descending order according to reliability to obtain a frozen bit index sequence $\mathbf{D}_F = \{46 ,45 ,30 ,43 ,29 ,39 ,... \}$. In a case where the parameter $d = 3$, three frozen bit indexes {46, 45, 30} with highest reliability are selected from the frozen bit index sequence as a candidate index sequence.

S510, select a target bit index $j = 46$ from the candidate index sequence, and adjust index types of the target bit index and the to-be-adjusted bit index.

Specifically, for the candidate index sequence {46, 45, 30}, it is determined that the bit indexes 46 and 45 belong to the second subcode, and the bit index 30 belongs to the first subcode. From the above, it may be seen that both the first subcode and the second subcode support to be decoded by the Fast-SC algorithm, so there are no elements in the candidate index sequence {46 ,45 ,30 } that do not support to be decoded by the Fast-SC algorithm. Therefore, the relative value relationship is first compared between $D_0 =46$ and the to-be-adjusted bit index $i = 60$. Since $D_0 < i$, it is to be determined whether $D_0$ still supports to be decoded by the Fast-SC algorithm after the code rate of the subcode of $D_0$ is adjusted: the bit index $D_0 =46$ is located in a $t = \lfloor D_0 / M \rfloor = 2$ nd segment, and a number of information index bit indexes in the 2nd segment is $k_2 = 1$, and after adding one information index bit, the parameter $k_2 = 2$. Since $2 \in \mathbf{S}$, that is, $D_0 = 46$ still supports to be decoded by the Fast-SC algorithm after the code rate of the subcode of $D_0$ is adjusted, the target bit index $j = 46$ is selected.

S511, update the information index bit index set of the polar sequence to $\mathbf{Q}_I^{r} = \{\mathbf{Q}_I^{r} \setminus \{60\}\} \cup \{46\} = \{46,31,47,55,59,61,62,63\}$ , where the updated frozen bit index set is $\mathbf{Q}_F^{r} = \mathbf{Q}_0^{r} \setminus \mathbf{Q}_I^{r}$.

S512, determine whether the adjusted third subcode supports to be decoded by the Fast-SC algorithm. If it does not support, the number of information bit indexes included in the third subcode is adjusted again with reference to the above-mentioned S507 to S511, until the third subcode is adjusted to support to be decoded by the Fast-SC algorithm, and if it supports, the adjustment of the polar sequence is completed.

S513, obtain a to-be-encoded sequence based on the polar sequence that has been adjusted and an input bit sequence {1,1,1,1,1,1,1,1}.

The process of performing S513 may refer to S204, which will not be repeated.

S514, encode the to-be-encoded sequence based on a generation matrix to obtain an encoded sequence, and send the encoded sequence.

The process of performing S514 may refer to S205, which will not be repeated.

Based on the method shown in FIG. 5, by decreasing the number of information bit indexes in the third subcode of the polar sequence with the length of 64, the third subcode may be enabled to support to be decoded by the Fast-SC algorithm as quickly as possible. In this way, it is enabled that the requirement for the subcode to be decoded by the Fast-SC algorithm may be met with fewer adjustments, thereby improving the adjustment efficiency of the subcode, and ensuring that all subcodes support to be decoded by the Fast-SC algorithm on the basis of improved adjustment efficiency, and then improving decoding performance. Meanwhile, in the method shown in FIG. 5, the target bit index is found in three bit indexes with reliability close to reliability of the to-be-adjusted bit index, and the index types are exchanged, so that information bits are transmitted on the polar channel with high channel quality (or high reliability) both before and after the bit index is adjusted, thereby ensuring the transmission performance of the entire communication system.

Assuming that the code length of the polar sequence is N=64, the total number of information bit indexes of the polar sequence is K=10, the preset decoding algorithm is the Fast-SC algorithm, the fast decoding set is **S** = {0,1,2,3,7,11,13,14,15,16 }, and the length for segmenting the polar sequence at equal intervals is 16, the method provided in the present disclosure is described in detail below.

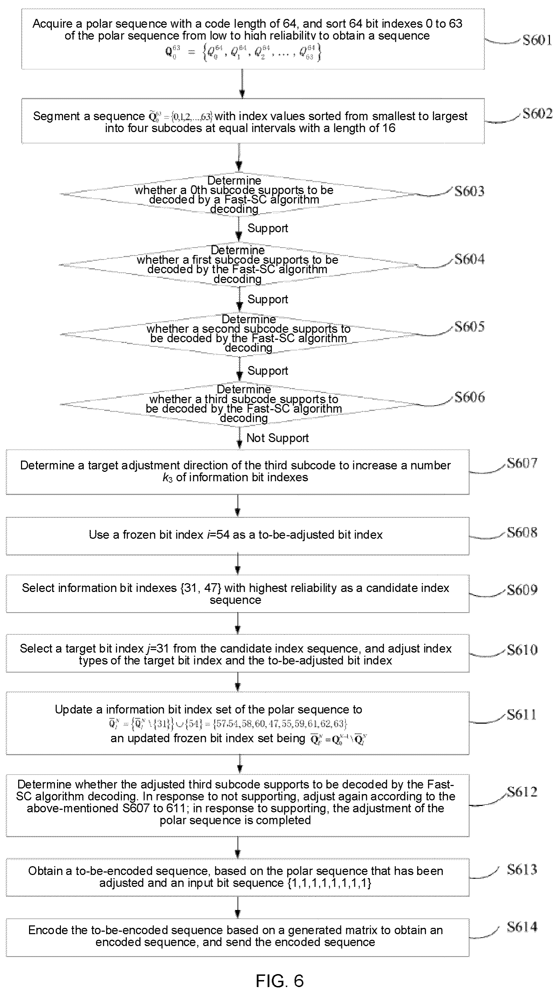

FIG. 6 is a flowchart of yet another encoding method provided in the present disclosure, as shown in FIG. 6, which includes the following.

S601, acquire a polar sequence with a code length of 64, sort 64 bit indexes 0 to 63 of the polar sequence from low to high reliability to obtain a sequence $\mathbf{Q}_0^N = \{Q_0^N, Q_1^N, Q_2^N, \ldots, Q_{63}^N\}$.

The implementation process of step S601 may refer to S501, which will not be repeated.

Furthermore, optionally, an information bit index set $\mathbf{Q}_I^N = \{57,58,60,31,47,55,59,61,62,63\}$ is generated by selecting 10 bit indexes with the highest reliability.

S602, segment at equal intervals with a length of 16, the sequence $\mathbf{Q}_0^{ys} = \{0,1,2,\ldots 63\}$ with index values sorted from small to large into $T=4$ four subcodes: $\mathbf{P}_0=\{0,1,2,\ldots,15\}$, $\mathbf{P}_1=\{16,17,18,\ldots,31\}$, $\mathbf{P}_1=\{16,17,18,\ldots,31\}$, and $\mathbf{P}_3=\{48,49,50,\ldots,63\}$.

S603, determine whether the 0th subcode supports to be decoded by the Fast-SC algorithm. In a case where the 0th subcode supports to be decoded by the Fast-SC algorithm, S604 is performed.

S603 is the same as S503, which will not be repeated.

S604: determine whether the first subcode supports to be decoded by the Fast-SC algorithm. In a case where the first subcode supports to be decoded by the Fast-SC algorithm, S605 is performed.

S604 is the same as S504, which will not be repeated.

S605: determine whether the second subcode supports to be decoded by the Fast-SC algorithm. In a case where the second subcode supports to be decoded by the Fast-SC algorithm, S606 is performed.

S605 is the same as S505, which will not be repeated.

S606: determine whether the third subcode supports to be decoded by the Fast-SC algorithm. In a case where the third subcode does not support to be decoded by the Fast-SC algorithm, S607 is performed.

S607 is the same as S507, which will not be repeated.

S607: determine that a target adjustment direction of the third subcode is to increase a number $k_3$ of information bit indexes.

Assuming that a first code rate threshold is 0.5, since the bit index set of the third subcode is $\mathbf{P}_3=\{48,49,50,\ldots,63\}$, a set $\mathbf{P}_3' = \mathbf{Q}_I^N \cap \mathbf{P}_3 = \{55,57,58,59,60,61,62,63\}$ is calculated. The number of information bit indexes of the subcode is $k_3 = |\mathbf{P}_3'| = 8$, and the code rate of the third subcode is $r = k_3 / M = 1/2 \geq 1/2$, so the number $k_3$ of information bit indexes in the segment needs to be increased.

S608, sort frozen bit indexes $\mathbf{P}_3'' = \mathbf{P}_3 \setminus \mathbf{P}_3'$ in the third subcode in descending order according to reliability to obtain an index sequence {54 ,53 ,51 ,56 ,52 ,50 ,49 ,48 }, obtain a frozen bit index with highest reliability $i = 54$, and use the frozen bit index $i = 54$ as a to-be-adjusted bit index.

S609: sort information bit indexes in all segments other than the third subcode in descending order according to reliability to obtain an information bit index sequence $\mathbf{D}_I = \{31,47\}$. In a case where the parameter $d = 3$, information bit indexes {31, 47} with highest reliability are selected from the information bit index sequence as a candidate index sequence.

S610, select a target bit index $j = 31$ from the candidate index sequence, and adjust index types of the target bit index and the to-be-adjusted bit index.

Specifically, for the candidate index sequence {31, 47}, there are no elements that do not support to be decoded by the Fast-SC algorithm. First, the relative value relationship of $D_0 = 31$ and the to-be-adjusted bit index $i = 54$ is compared. Since $D_0 < i$, it is necessary to determine whether $D_0$ may still support to be decoded by the Fast-SC algorithm after the code rate of the subcode of $D_0$ is adjusted: the bit index $D_0 = 31$ is located in a $t = \lfloor D_0 / M \rfloor = 1$ st segment, and the number of information bit indexes in the 1st segment is $k_1 = 1$, and after reducing one information bit, the parameter $k_1 = 0$. Since $0 \in \mathbf{S}$, that is, $D_0 = 31$ may still support to be decoded by the Fast-SC algorithm after the code rate of the segment of $D_0 = 31$ is adjusted, the target bit index $j = 31$ may be selected.

S611, update the information index bit index set of the polar sequence to

$$\mathbf{Q}_I^{i'} = \left\{ \mathbf{Q}_I^{i'} \setminus \{31\} \right\} \cup \{54\} = \{57,54,58,60,47,55,59,61,62,63\}$$ , where the updated frozen bit index set is

$$\mathbf{Q}_F^{i'} = \mathbf{Q}_0^{N-1} \setminus \mathbf{Q}_I^{i'}.$$

S612, determine whether the adjusted third subcode supports to be decoded by the Fast-SC algorithm. If it does not support, the number of information bit indexes included in the third subcode is adjusted again with reference to the above-mentioned S607 to S611, until the third subcode is adjusted to support to be decoded by the Fast-SC algorithm, and if it supports, the adjustment of the polar sequence is completed.

S613, obtain a to-be-encoded sequence based on the polar sequence that has been adjusted and an input bit sequence {1, 1, 1, 1, 1, 1, 1, 1}.

The process of performing S613 may refer to S204, which will not be repeated.

S614, encode the to-be-encoded sequence based on a generation matrix to obtain an encoded sequence, and send the encoded sequence.

The process of performing S614 may refer to S205, which will not be repeated.

Based on the method shown in FIG. 6, by increasing the number of information bit indexes in the third subcode of the polar sequence with the length of 64, the third subcode may be enabled to support to be decoded by the Fast-SC algorithm as quickly as possible. In this way, it is enabled that the requirement for the subcode to be decoded by the Fast-SC algorithm may be met with fewer adjustments, thereby improving the adjustment efficiency of the subcode, and ensuring that all subcodes support to be decoded by the Fast-SC algorithm on the basis of improved adjustment efficiency, and then improving decoding performance. Meanwhile, in the method shown in FIG. 6, the target bit index is found in two bit indexes with reliability close to reliability of the to-be-adjusted bit index, and the index types are exchanged, so that information bits are transmitted on the polar channel with high channel quality (or high reliability) both before and after the bit index is adjusted, thereby ensuring the transmission performance of the entire communication system.

The above-mentioned FIG. 5 and FIG. 6 take an example of selecting the bit index in the subcode that supports to be decoded by the Fast-SC algorithm as the target bit index for explanations, respectively, and unlike FIG. 5 and FIG. 6, the following takes an example of selecting the bit index in the subcode that does not support to be decoded by the Fast-SC algorithm as the target bit index for explanations.

For example, it is assumed that the code length of the polar sequence is N=64, the total number of information bit indexes of the polar sequence is K=20, the preset decoding algorithm is the Fast-SC algorithm, the fast decoding set is S = {0,1,2,3,7,11,13,14,15,16}, the length of the subcode of the polar sequence at equal intervals is 16, and the information bit set

$$\mathbf{Q}_I^{i'} = \mathbf{Q}_I^{i'} = \{27, 39, 29, 43, 30, 45, 51, 46, 53, 54, 57, 58, 60, 31, 47, 55, 59, 61, 62, 63\}.$$

The bit index set of the 0th subcode is $\mathbf{P}_0$ = {0,1,2,...,15}, and the set $\mathbf{P}_0^{i} = \mathbf{Q}_I^{i'} \cap \mathbf{P}_0$ is calculated. The number of information bit indexes of the subcode is $k_0 = |\mathbf{P}_0^{i}| = 0$ , and since $k_0 \in$ **S**, it is determined that the subcode can support to be decoded by the Fast-SC algorithm, and the code rate does not need to be adjusted.

The bit index set of the first subcode is $\mathbf{P}_1$ = {16,17,18,...,31}, and the set $\mathbf{P}_1^{i} = \mathbf{Q}_I^{i'} \cap \mathbf{P}_1 = \{27,29,30,31\}$ is calculated. The number of information bit indexes of the subcode is $k_1 = |\mathbf{P}_1^{i}| = 4$ , and since $k_1 \notin$ **S**, it is determined that the subcode cannot support to be decoded by the Fast-SC algorithm, and the code rate needs to be adjusted.

The bit index set of the second subcode is $\mathbf{P}_2$ = {32,33,34,...,47}, and the set $\mathbf{P}_2^{i} = \mathbf{Q}_I^{i'} \cap \mathbf{P}_2 = \{39,43,45,46,47\}$ is calculated. The number of information bit indexes of the subcode is $k_2 = |\mathbf{P}_2^{i}| = 5$ , and since $k_2 \notin$ **S**, it is determined that the subcode cannot support to be decoded by the Fast-SC algorithm, and the code rate needs to be adjusted.

The bit index set of the third subcode is $\mathbf{P}_3$ = {48,49,50,...,63}, and the set $\mathbf{P}_3^{i} = \mathbf{Q}_I^{i'} \cap \mathbf{P}_3 = \mathbf{P}_3 \setminus \{48,49,50,52,56\}$ is calculated. The number of information bit indexes of this subcode is $k_3 = |\mathbf{P}_3^{i}| = 11$ , and since $k_3 \in$ **S**, it is determined that the subcode can support to be decoded by the Fast-SC algorithm, and the code rate does not need to be adjusted.

When adjusting the first subcode, since the code rate of the first subcode is $r = k_1 / M = 1/4 < 1/2$ , the number $k_1$ of information bit indexes in the subcode needs to be decreased. The information bit indexes $\mathbf{P}_1$ in the current subcode are sorted in ascending order according to reliability to obtain an index sequence {27,29,30,31}, so the least reliable information bit index is $i = 27$. Frozen bit indexes in all segments other than the current segment are sorted in descending order according to reliability to obtain a frozen bit index sequence $\mathbf{D}_F = \{56, 52, 15, 50, 44, 49, 42, ...\}$. The parameter is $d = 6$, and first, it is to be determined whether there is an element belonging to a segment that cannot support to be decoded by the Fast-SC algorithm among the first six elements of the sequence $\mathbf{D}_F$. The segment serial number in which the index sequence $D_{0\sim5} = \{56, 52, 15, 50, 44, 49\}$ is located is $\mathbf{T}_D = \{3, 3, 0, 3, 2, 3\}$. From the above, it can be known that the second subcode belongs to the segment that cannot support to be decoded by the Fast-SC algorithm, so $D_4 = 44$ is prioritized to be select as the target bit index, that is, $j = 44$. The updated information bit index is $\mathbf{Q}_I^{i'} = \{\mathbf{Q}_I^{i'} \setminus \{27\}\} \cup \{44\}$, and the updated $\mathbf{Q}_F^{i'} = \mathbf{Q}_0^{i'} \setminus \mathbf{Q}_I^{i'}$.

For another example, it is assumed that the code length of the polar sequence is N=64, the total number of information bit indexes of the polar sequence is K=20, the preset decoding algorithm is the Fast-SC algorithm, the fast decoding set is S = {0,1,2,3,7,11,13,14,15,16}, the length of the subcode of the polar sequence at equal intervals is 16, and the information bit set is $\mathbf{Q}_I^{i'} = \mathbf{Q}_I^{v\to} =$ {27, 39, 29, 43, 30, 45, 51, 46, 53, 54, 57, 58, 60, 31, 47, 55, 59, 61, 62, 63}. The first number set is $S_{sup} = \{4,9,10,12\}$ and the second number set is $S_{sub} = \{5,6,8\}$.

The bit index set of the 0th subcode is $\mathbf{P}_0 = \{0,1,2,...,15\}$, and the set $\mathbf{P}_0' = \mathbf{Q}_I^{v\to} \cap \mathbf{P}_0$ is calculated. The number of information bit indexes of the subcode is $k_0 = |\mathbf{P}_0'| = 0$, and since $k_0 \in S$, it is determined that the subcode can support to be decoded by the Fast-SC algorithm, and the code rate does not need to be adjusted.

The bit index set of the first subcode is $\mathbf{P}_1 = \{16,17,18,...,31\}$, and the set $\mathbf{P}_1' = \mathbf{Q}_I^{v\to} \cap \mathbf{P}_1 = \{27,29,30,31\}$ is calculated. The number of information bit indexes of the subcode is $k_1 = |\mathbf{P}_1'| = 4$, and since $k_1 \notin S$, it is determined that the subcode cannot support to be decoded by the Fast-SC algorithm, and the code rate needs to be adjusted.

The bit index set of the second subcode is $\mathbf{P}_2 = \{32,33,34,...,47\}$, and the set $\mathbf{P}_2' = \mathbf{Q}_I^{v\to} \cap \mathbf{P}_2 = \{39,43,45,46,47\}$ is calculated. The number of information bit indexes of the subcode is $k_2 = |\mathbf{P}_2'| = 5$, and since $k_2 \notin S$, it is determined that the subcode cannot support to be decoded by the Fast-SC algorithm, and the code rate needs to be adjusted.

The bit index set of the third subcode is $\mathbf{P}_3 = \{48,49,50,...,63\}$, and the set $\mathbf{P}_3' = \mathbf{Q}_I^{v\to} \cap \mathbf{P}_3 = \mathbf{P}_3 \setminus \{48,49,50,52,56\}$ is calculated. The number of information bit indexes of this subcode is $k_3 = |\mathbf{P}_3'| = 11$, and since $k_3 \in S$, it is determined that the subcode can support to be decoded by the Fast-SC algorithm, and the code rate does not need to be adjusted.

When adjusting the first subcode, since the code rate of the first subcode is $k_1 \in S_{sup}$, the number $k_1$ of information bit indexes in the subcode needs to be increased. The frozen bit indexes $\mathbf{P}_1'$ in the current subcode are sorted in descending order according to reliability to obtain an index sequence {23,15,28,22,25,26,...}, so the most reliable frozen bit index is $i = 23$. Information bit indexes in all segments other than the current segment are sorted in ascending order according to reliability to obtain an information bit index sequence $D_I = \{39,43,45,51,46,53,54...\}$. The parameter is $d = 6$, and first, it is to be determined whether there is an element belonging to a segment that cannot be quickly decoded among the first six elements of the sequence $D_I$. The segment serial number in which the index sequence $D_{0\sim5} = \{39,43,45,51,46,53\}$ is located is $T_D = \{2,2,2,3,2,3\}$. From the above, it can be known that the second subcode belongs to the segment that cannot be quickly decoded, so $D_0 = 39$ is prioritized to be select as the target bit index, that is, $j = 39$. The updated information bit index is $\mathbf{Q}_I^{i'} = \{\mathbf{Q}_I^{i'} \setminus \{39\}\} \cup \{23\}$, and the updated $\mathbf{Q}_F^{i'} = \mathbf{Q}_0^{i'-1} \setminus \mathbf{Q}_I^{i'}$.

It can be understood that, in order to implement the above-mentioned functions, an encoding apparatus includes the corresponding hardware structures and/or software modules for performing the respective functions. Those skilled in the art should easily recognize that the present disclosure can be implemented in the form of hardware or a combination of hardware and computer software, in conjunction with the algorithmic steps of the respective examples described in the embodiments of the present disclosure. Whether a certain function is performed by hardware or computer software-driven hardware depends on the specific application and design constraints of the technical solutions. Professional technicians may use different methods to implement the described functions, for each specific application, but such an implementation should not be considered beyond the scope of the present disclosure.

In the embodiments of the present disclosure, the encoding apparatus may be divided into functional modules according to the above-mentioned method embodiments, and for example, each functional module may be divided corresponding to each function, or two or more functions may be integrated into one functional module. The above-mentioned integrated module may be implemented in the form of hardware or may be implemented in the form of software. It should be noted that the division of modules in the embodiments of the present disclosure is illustrative, and is merely a kind of logical functional division, and there may be other division methods in actual implementations. The example in which each functional module may be divided corresponding to each function is taken for explanation below.

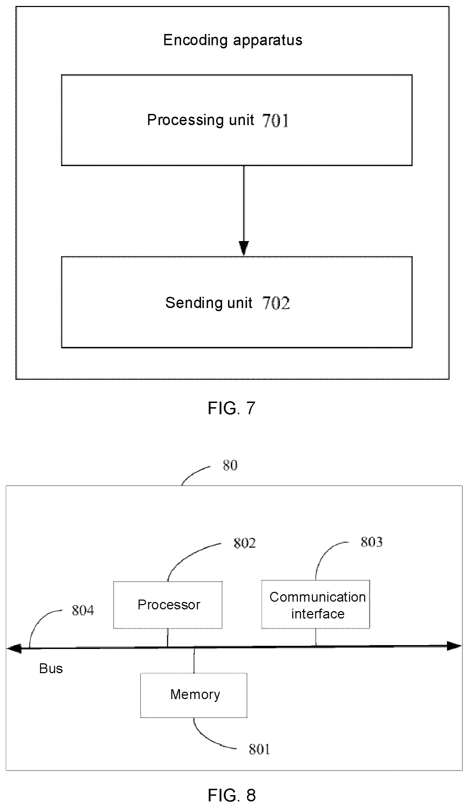

FIG. 7 is a structural schematic diagram of an encoding apparatus provided in the embodiments of the present disclosure, and the encoding apparatus may perform the encoding method provided in the above-mentioned method embodiments. As shown in FIG. 7, the encoding apparatus includes: a processing unit 701 and a sending unit 702.

The processing unit 701 is configured to adjust a number of information bit indexes of a first subcode that does not support to be decoded by a preset decoding algorithm among a plurality of subcodes of a polar sequence, based on a target adjustment direction, where the target adjustment direction includes increasing the number of information bit indexes of the first subcode or decreasing the number of information bit indexes of the first subcode; obtain a sequence to be encoded based on the polar sequence that has been adjusted and the input bit sequence; and encode the sequence to be encoded based on the generation matrix to obtain an encoded sequence.

The sending unit 702 is configured to send the encoded sequence.

In a possible implementation, the processing unit 701 is specifically configured to: acquire a to-be-adjusted bit index in the first subcode according to the target adjustment direction; select a target bit index from a candidate index sequence other than the first subcode, where the candidate index sequence includes d bit indexes with an index type different from an index type of the to-be-adjusted bit index and with reliability closest to reliability of the to-be-adjusted bit index, and d is a preset number; adjust index types of the to-be-adjusted bit index and the target bit index.

In a possible implementation, in response that the target adjustment direction is to increase the number of information bit indexes of the first subcode, the to-be-adjusted bit index is an frozen bit index with reliability greater than a first reliability threshold in the first subcode; the candidate index sequence includes d information bit indexes with lowest reliability, among information bit indexes in the polar sequence other than the first subcode.

In a possible implementation, in response that the target adjustment direction is to decrease the number of information bit indexes of the first subcode, the to-be-adjusted bit index is an information bit index with reliability less than a second reliability threshold in the first subcode; the candidate index sequence includes d frozen bit indexes with highest reliability, among frozen bit indexes in the polar sequence other than the first subcode.

In a possible implementation, the target bit index is a bit index in a second subcode that does not support to be decoded by the preset decoding algorithm, in the candidate index sequence; or the target bit index is a bit index with an index value greater than an index value of the to-be-adjusted bit index, in a third subcode that supports to be decoded by the preset decoding algorithm, in the candidate index sequence; or the target bit index is a bit index with an index value less than an index value of the to-be-adjusted bit index, in a third subcode that supports to be decoded by the preset decoding algorithm, in the candidate index sequence, and the third subcode supports to be decoded by the preset decoding algorithm both before and after the index type of the target bit index is adjusted.

In a possible implementation, the target adjustment direction is determined according to a current code rate of the first subcode.

In a possible implementation, in response that the current code rate of the first subcode is less than a first code rate threshold, the target adjustment direction is to decrease the number of information bit indexes of the first subcode; in response that the current code rate of the first subcode is greater than a second code rate threshold, the target adjustment direction is to increase the number of information bit indexes of the first subcode.

In a possible implementation, the target adjustment direction is determined according to the number of information bit indexes of the first subcode and a preset set; where the preset set includes at least one of: a first number set or a second number set; the first number set indicates a number of information bit indexes currently included in a subcode with information bit indexes to be increased; the second number set indicates a number of information bit indexes currently included in a subcode with information bit indexes to be decreased.

In a possible implementation, in response that the number of information bit indexes of the first subcode belongs to the first number set, the target adjustment direction is to increase the number of information bit indexes of the first subcode; and/or, in response that the number of information bit indexes of the first subcode belongs to the second number set, the target adjustment direction is to decrease the number of information bit indexes of the first subcode.

In a possible implementation, the number of information bit indexes of the first subcode does not belong to a third number set, where the third number set indicates a number of information bit indexes of a subcode that supports to be decoded by the preset decoding algorithm.

In a possible implementation, an information bit index combination of the first subcode does not belong to a subcode pattern, where the subcode pattern is used to indicate an information bit index combination of a subcode that supports to be decoded by the preset decoding algorithm.

In a possible implementation, the subcode pattern is pre-set; or the subcode pattern is determined according to reliability of information bit indexes and/or a type of the subcode that supports to be decoded by the preset decoding algorithm.

In a possible implementation, the polar sequence is pre-specified; or the polar sequence is obtained by any one of algorithms: a Gaussian approximation algorithm, a density evolution algorithm, a PW sequence algorithm, and a reinforcement learning algorithm.

In the case of implementing the functions of the above-mentioned integrated modules in the form of hardware, the embodiments of the present disclosure provide another possible structure of the encoding apparatus involved in the above-mentioned embodiments. As shown in FIG. 8, the encoding apparatus 80 includes: a processor 802 and a bus 804. Optionally, the encoding apparatus may also include a memory 801; and optionally, the encoding apparatus may also include a communication interface 803.

The processor 802 may implement or perform various exemplary logical blocks, modules and circuits described in conjunction with the embodiments of the present disclosure. The processor 802 may be a central processing unit, a general-purpose processor, a digital signal processor, an application specific integrated circuit, a field programmable gate array or other programmable logic devices, a transistor logic device, a hardware component or any combination thereof, which may implement or perform various exemplary logical blocks, modules and circuits described in conjunction with the embodiments of the present disclosure. The processor 802 may also be a combination that implements computing functions, for example, including a combination of one or more microprocessors, a combination of a digital signal processor (DSP) and a microprocessor, or the like.

The communication interface 803 is configured to connect with other devices via a communication network. The communication network may be an Ethernet, a radio access network, a wireless local area network (WLAN).

The memory 801 may be, but be not limited to, a read-only memory (ROM) or other types of static storage devices capable of storing static information and instructions, a random access memory (RAM) or other types of dynamic storage devices capable of storing information and instructions, or may also be an electrically erasable programmable read-only memory (EEPROM), a magnetic disk storage medium or other magnetic storage devices, or any other medium capable of being used to carry or store the desired program codes in the form of instructions or data structures and capable of being accessed by a computer.

As a possible implementation, the memory 801 may exist independently of the processor 802, and the memory 801 may be connected to the processor 802 via the bus 804 and used for storing instructions or program codes. The processor 802, when calling and executing the instructions or program codes stored in the memory 801, is capable of implementing the encoding method provided by the embodiments of the present disclosure.

In another possible implementation, the memory 801 may also be integrated with the processor 802.

The bus 804 may be an extended industry standard architecture (EISA) bus or the like. Buses 804 may be divided into address buses, data buses, control buses, and the like. For the convenience of representation, only one thick line is used in FIG. 8 for representation, but it does not mean that there is only one bus or one type of bus.

Some embodiments of the present disclosure provide a computer-readable storage medium (e.g., a non-transitory computer-readable storage medium), and the computer-readable storage medium has stored computer program instructions therein that, when running on a computer, cause the computer to perform the encoding method as described in any of the above-mentioned embodiments.

Exemplarily, the above-mentioned computer-readable storage medium may include, but be not limited to, a magnetic storage device (e.g., a hard disk, a floppy disk or a magnetic tape, etc.), an optical disk (e.g., a Compact Disk (CD) or a Digital Versatile Disk (DVD), etc.), a smart card and a flash memory device (e.g., an Erasable Programmable Read-Only Memory (EPROM), a card, a stick or a key driver, etc.). The various computer-readable storage media described in the present disclosure may represent one or more devices and/or other machine-readable storage media for storing information. The term "machine-readable storage medium" may include, but be not limited to, a radio channel and various other media capable of storing, containing, and/or carrying instructions and/or data.

The embodiments of the present disclosure provide a communication system that includes the encoding apparatus as described in any one of the above-mentioned embodiments and a decoding apparatus. The encoding apparatus is configured to implement the encoding method described in any one of the above-mentioned embodiments, and the decoding apparatus is configured to decode the encoded sequence sent from the encoding apparatus, based on the preset decoding algorithm.

The embodiments of the present disclosure further provide a computer-readable storage medium. All or a part of the procedures in the method embodiments mentioned above may be completed by related hardware indicated by computer instructions, and the program may be stored in the computer-readable storage medium mentioned above. The program, when executed, may include the procedures of the method embodiments mentioned above. The computer-readable storage medium may be or a memory of any one of the aforementioned embodiments. The above-mentioned computer-readable storage medium may also be an external storage device of the device or apparatus mentioned above, e.g., a plug-in hard disk, a smart memory card (smart media card, SMC), a secure digital (SD) card, a flash card, etc., equipped on the device or apparatus mentioned above. Furthermore, the computer-readable storage medium mentioned above may further include both an internal storage unit and an external storage device of the device or apparatus mentioned above. The computer-readable storage medium mentioned above is used to store the computer program mentioned above, and other programs and data required for the device or apparatus mentioned above. The computer-readable storage medium mentioned above may further be used to temporarily store data that has been output or is to be output.

The embodiments of the present disclosure further provide a computer program product, the computer product contains a computer program, the computer program product, when executed on a computer, causes the computer to perform any one of the methods provided in the above embodiments.

Although the present disclosure is described herein in conjunction with respective embodiments, other variations of the disclosed embodiments may be understood and implemented by those skilled in the art by viewing the drawings, the disclosed content, and the attached claims, in the process of implementing the claimed processes of the present disclosure. In the claims, the word "comprise/comprises/comprising" does not exclude other components or steps, and "a/an" or "one" does not exclude multiple cases. A single processor or other unit may implement functions of several items listed in the claims. Although certain measures are recorded in dependent claims different from each other, it does not mean that these measures cannot be combined to exert a good effect.

Although the present disclosure is described in conjunction with specific features and embodiments thereof, it is apparent that various modifications and combinations may be made thereto without departing from the spirit and scope of the present disclosure. Accordingly, the specification and drawings are merely exemplary explanations of the present disclosure as defined by the attached claims and are deemed to cover any and all modifications, variations, combinations or equivalents within the scope of the present disclosure. Obviously, those skilled in the art may make various changes and variations to the present disclosure without departing from the spirit and scope of the present disclosure. In this way, if these modifications and variations of the present disclosure fall within the scope of the claims of the present disclosure and their equivalent technologies, the present disclosure is also intended to include these modifications and variations therein.

The above is merely specific implementations of the present disclosure, but the protection scope of the present disclosure is not limited thereto. Any change or replacement within the technical scope disclosed in the present disclosure shall be included in the protection scope of the present disclosure. Therefore, the protection scope of the present disclosure should be based on the protection scope of the claims.

**Claims**

1. An encoding method, **characterized by** comprising:

   adjusting a number of information bit indexes of a first subcode that does not support to be decoded by a preset decoding algorithm among a plurality of subcodes of a polar sequence, based on a target adjustment direction; wherein the target adjustment direction comprises increasing the number of information bit indexes of the first subcode or decreasing the number of information bit indexes of the first subcode;
   obtaining a sequence to be encoded based on the polar sequence that has been adjusted and the input bit sequence; and
   encoding the sequence to be encoded based on the generation matrix to obtain an encoded sequence, and sending the encoded sequence.

2. The method according to claim 1, wherein adjusting the number of information bit indexes of the first subcode that does not support to be decoded by the preset decoding algorithm among the plurality of subcodes of the polar sequence, comprises:

   acquiring a to-be-adjusted bit index in the first subcode according to the target adjustment direction;
   selecting a target bit index from a candidate index sequence other than the first subcode; wherein the candidate index sequence comprises d bit indexes with an index type different from an index type of the to-be-adjusted bit index and with reliability closest to reliability of the to-be-adjusted bit index, and d is a preset number; and
   adjusting index types of the to-be-adjusted bit index and the target bit index;
   wherein the index types comprise: an information bit index and a frozen bit index.

3. The method according to claim 2, wherein in response that the target adjustment direction is to increase the number of information bit indexes of the first subcode, the to-be-adjusted bit index is an frozen bit index with reliability greater than a first reliability threshold in the first subcode; the candidate index sequence comprises d information bit indexes with lowest reliability, among information bit indexes in the polar sequence other than the first subcode.

4. The method according to claim 2, wherein in response that the target adjustment direction is to decrease the number of information bit indexes of the first subcode, the to-be-adjusted bit index is an information bit index with reliability less than a second reliability threshold in the first subcode; the candidate index sequence comprises d frozen bit indexes with highest reliability, among frozen bit indexes in the polar sequence other than the first subcode.

5. The method according to any one of claims 2 to 4, wherein

the target bit index is a bit index in a second subcode that does not support to be decoded by the preset decoding algorithm, in the candidate index sequence; or
the target bit index is a bit index with an index value greater than an index value of the to-be-adjusted bit index, in a third subcode that supports to be decoded by the preset decoding algorithm, in the candidate index sequence; or
the target bit index is a bit index with an index value less than an index value of the to-be-adjusted bit index, in a third subcode that supports to be decoded by the preset decoding algorithm, in the candidate index sequence, and the third subcode supports to be decoded by the preset decoding algorithm both before and after the index type of the target bit index is adjusted.

6. The method according to claim 1, wherein the target adjustment direction is determined according to a current code rate of the first subcode.

7. The method according to claim 6, wherein
in response that the current code rate of the first subcode is less than a first code rate threshold, the target adjustment direction is to decrease the number of information bit indexes of the first subcode; or in response that the current code rate of the first subcode is greater than a second code rate threshold, the target adjustment direction is to increase the number of information bit indexes of the first subcode.

8. The method according to claim 1, wherein the target adjustment direction is determined according to the number of information bit indexes of the first subcode and a preset set; wherein the preset set comprises at least one of: a first number set or a second number set; the first number set indicates a number of information bit indexes currently comprised in a subcode with information bit indexes to be increased; the second number set indicates a number of information bit indexes currently comprised in a subcode with information bit indexes to be decreased.

9. The method according to claim 8, wherein in response that the number of information bit indexes of the first subcode belongs to the first number set, the target adjustment direction is to increase the number of information bit indexes of the first subcode; or
in response that the number of information bit indexes of the first subcode belongs to the second number set, the target adjustment direction is to decrease the number of information bit indexes of the first subcode.

10. The method according to claim 1, wherein the number of information bit indexes of the first subcode does not belong to a third number set, wherein the third number set indicates a number of information bit indexes of a subcode that supports to be decoded by the preset decoding algorithm.

11. The method according to claim 1, wherein an information bit index combination of the first subcode does not belong to a subcode pattern, wherein the subcode pattern is used to indicate an information bit index combination of a subcode that supports to be decoded by the preset decoding algorithm.

12. The method according to claim 11, wherein

the subcode pattern is pre-set; or
the subcode pattern is determined according to reliability of information bit indexes and/or a type of the subcode that supports to be decoded by the preset decoding algorithm.

13. The method according to claim 1, wherein

the polar sequence is pre-specified; or
the polar sequence is obtained by any one of algorithms: a Gaussian approximation algorithm, a density evolution algorithm, a PW sequence algorithm, and a reinforcement learning algorithm.

14. An encoding apparatus, **characterized by** comprising: a processor and a memory;

wherein the memory stores instructions executable by the processor;
the processor is configured to execute the instructions, to cause the communication apparatus to implement the encoding method according to any one of claims 1 to 13.

15. A computer-readable storage medium, **characterized in that** the computer-readable storage medium comprises computer instructions, and the computer instructions, when executed on a computer, cause the computer to perform the encoding method according to any one of claims 1 to 13.

FIG. 1A

FIG. 1B

Acquire a plurality of subcodes of a polar sequence — S201

Traverse each subcode of the plurality of subcodes to determine whether the subcode supports to be decoded by a preset decoding algorithm, in response that the subcode supports to be decoded by the preset decoding algorithm, determine whether a next subcode supports to be decoded by the preset decoding algorithm; in response that the subcode does not support to be decoded by the preset decoding algorithm, perform S203 — S202

Adjust a first subcode that does not support to be decoded by the preset decoding algorithm in the polar sequence, and a number of information bit indexes of the first subcode, based on a target adjustment direction — S203

obtain a to-be-encoded sequence based on the polar sequence that has been adjusted and an input bit sequence — S204

encode the to-be-encoded sequence based on a generation matrix to obtain an encoded sequence, and send the encoded sequence — S205

FIG. 2

FIG. 3A

FIG. 3B

FIG. 4A

FIG. 4B

Acquire a polar sequence with a code length of 64, and sort 64 bit indexes 0 to 63 of the polar sequence from low to high reliability to obtain a sequence
$$\mathbf{Q}_0^{63} = \left\{ Q_0^{64}, Q_1^{64}, Q_2^{64}, \dots, Q_{63}^{64} \right\}$$
— S501

Segment a sequence $\bar{Q}_0^{63} = \{0,1,2,\dots,63\}$ with index values sorted from smallest to largest into four subcodes at equal intervals with a length of 16
— S502

Determine whether a 0th subcode supports to be decoded by a Fast-SC algorithm decoding
— S503

Support

Determine whether a first subcode supports to be decoded by the Fast-SC algorithm decoding
— S504

Support

Determine whether a second subcode supports to be decoded by the Fast-SC algorithm decoding
— S505

Support

Determine whether a third subcode supports to be decoded by the Fast-SC algorithm decoding
— S506

Not Support

Determine a target adjustment direction of the third subcode to decrease a number $k_3$ of information bit indexes
— S507

Use an information bit index $i$=60 as a to-be-adjusted bit index
— S508

Select three frozen bit indexes {46, 45, 30} with highest reliability from a frozen bit index sequence, as a candidate index sequence
— S509

Select a target bit index $j$=46 from the candidate index sequence, and adjust index types of the target bit index and the to-be-adjusted bit index
— S510

Update a information bit index set of the polar sequence to
$$\bar{Q}_I^N = \{\bar{Q}^N \setminus \{60\}\} \cup \{46\} = \{46,31,47,55,59,61,62,63\} ,$$
an updated frozen bit index set being $\bar{Q}_F^N = Q_0^{N-1} \setminus \bar{Q}_I^N$
— S511

Determine whether the adjusted third subcode supports to be decoded by the Fast-SC algorithm. In response to not supporting, adjust again according to the above-mentioned S507 to S511; in response to supporting, the adjustment of the polar sequence is completed
— S512

Obtain a to-be-encoded sequence, based on the polar sequence that has been adjusted and an input bit sequence {1,1,1,1,1,1,1,1}
— S513

Encode the to-be-encoded sequence based on a generated matrix to obtain an encoded sequence, and send the encoded sequence
— S514

FIG. 5

Acquire a polar sequence with a code length of 64, and sort 64 bit indexes 0 to 63 of the polar sequence from low to high reliability to obtain a sequence
$$\mathbf{Q}_0^{63} = \left\{ Q_0^{64}, Q_1^{64}, Q_2^{64}, \ldots, Q_{63}^{64} \right\}$$ — S601

Segment a sequence $\tilde{\mathbf{Q}}_0^{63} = \{0,1,2,\ldots,63\}$ with index values sorted from smallest to largest into four subcodes at equal intervals with a length of 16 — S602

Determine whether a 0th subcode supports to be decoded by a Fast-SC algorithm decoding — S603

Support

Determine whether a first subcode supports to be decoded by the Fast-SC algorithm decoding — S604

Support

Determine whether a second subcode supports to be decoded by the Fast-SC algorithm decoding — S605

Support

Determine whether a third subcode supports to be decoded by the Fast-SC algorithm decoding — S606

Not Support

Determine a target adjustment direction of the third subcode to increase a number $k_3$ of information bit indexes — S607

Use a frozen bit index $i$=54 as a to-be-adjusted bit index — S608

Select information bit indexes {31, 47} with highest reliability as a candidate index sequence — S609

Select a target bit index $j$=31 from the candidate index sequence, and adjust index types of the target bit index and the to-be-adjusted bit index — S610

Update a information bit index set of the polar sequence to
$$\overline{\mathbf{Q}}_I^y = \{ \overline{\mathbf{Q}}_I^y \setminus \{31\} \} \cup \{54\} = \{57,54,58,60,47,55,59,61,62,63\}$$
an updated frozen bit index set being $\overline{\mathbf{Q}}_F^y = \mathbf{Q}_0^{N-1} \setminus \overline{\mathbf{Q}}_I^y$ — S611

Determine whether the adjusted third subcode supports to be decoded by the Fast-SC algorithm decoding. In response to not supporting, adjust again according to the above-mentioned S607 to 611; in response to supporting, the adjustment of the polar sequence is completed — S612

Obtain a to-be-encoded sequence, based on the polar sequence that has been adjusted and an input bit sequence {1,1,1,1,1,1,1,1} — S613

Encode the to-be-encoded sequence based on a generated matrix to obtain an encoded sequence, and send the encoded sequence — S614

FIG. 6

Encoding apparatus

Processing unit 701

Sending unit 702

FIG. 7

80

802

803

804

Processor

Communication
interface

Bus

Memory

801

FIG. 8

## INTERNATIONAL SEARCH REPORT

| International application No. |
|---|
| **PCT/CN2024/076806** |

| A. | CLASSIFICATION OF SUBJECT MATTER |
|---|---|

H03M13/13(2006.01)i; H04L1/00(2006.01)i

According to International Patent Classification (IPC) or to both national classification and IPC

| B. | FIELDS SEARCHED |
|---|---|

Minimum documentation searched (classification system followed by classification symbols)

IPC: H03M H04L

Documentation searched other than minimum documentation to the extent that such documents are included in the fields searched

Electronic data base consulted during the international search (name of data base and, where practicable, search terms used)

CNABS; CNTXT; CNKI; WPABS; DWPI; USTXT; WOTXT; EPTXT; IEEE: 极性, 极化, 编码, 译码, 序列, 索引, 调节, 调整, 改变, 增加, 增大, 减小, 降低, 码率, 阈值, 门限, 快速串行抵消, polar, encode, decode, sequence, index, change, adjust, increase, decrease, code rate, threshold, fast SC

| C. | DOCUMENTS CONSIDERED TO BE RELEVANT |
|---|---|

| Category* | Citation of document, with indication, where appropriate, of the relevant passages | Relevant to claim No. |
|---|---|---|
| A | CN 110890894 A (HUAWEI TECHNOLOGIES CO., LTD.) 17 March 2020 (2020-03-17) description, paragraphs [0001]-[0274] | 1-15 |
| A | CN 108809482 A (HUAWEI TECHNOLOGIES CO., LTD.) 13 November 2018 (2018-11-13) entire document | 1-15 |
| A | CN 109155634 A (HUAWEI TECHNOLOGIES CO., LTD.) 04 January 2019 (2019-01-04) entire document | 1-15 |
| A | CN 111034080 A (QUALCOMM INC.) 17 April 2020 (2020-04-17) entire document | 1-15 |
| A | CN 115720124 A (HUAWEI TECHNOLOGIES CO., LTD.) 28 February 2023 (2023-02-28) entire document | 1-15 |
| A | CN 114337926 A (HANGZHOU DIANZI UNIVERSITY) 12 April 2022 (2022-04-12) entire document | 1-15 |
| A | CN 111447042 A (HUAWEI TECHNOLOGIES CO., LTD.) 24 July 2020 (2020-07-24) entire document | 1-15 |

☐ Further documents are listed in the continuation of Box C.   ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **23 April 2024** | **24 April 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2024/076806**

| Patent document cited in search report | | | Publication date (day/month/year) | Patent family member(s) | | | Publication date (day/month/year) |
|---|---|---|---|---|---|---|---|
| CN | 110890894 | A | 17 March 2020 | WO | 2020048537 | A1 | 12 March 2020 |
| CN | 108809482 | A | 13 November 2018 | US | 2020059253 | A1 | 20 February 2020 |
| | | | | US | 11005504 | B2 | 11 May 2021 |
| | | | | JP | 7216011 | B2 | 31 January 2023 |
| | | | | EP | 3618320 | A1 | 04 March 2020 |
| | | | | EP | 3618320 | A4 | 16 September 2020 |
| | | | | EP | 3618320 | B1 | 18 May 2022 |
| | | | | WO | 2018196786 | A1 | 01 November 2018 |
| | | | | BR | 112019022474 | A2 | 12 May 2020 |
| CN | 109155634 | A | 04 January 2019 | US | 2019081646 | A1 | 14 March 2019 |
| | | | | US | 10541710 | B2 | 21 January 2020 |
| | | | | EP | 3375098 | A1 | 19 September 2018 |
| | | | | EP | 3375098 | B1 | 30 November 2022 |
| | | | | WO | 2017194133 | A1 | 16 November 2017 |
| CN | 111034080 | A | 17 April 2020 | WO | 2019040218 | A1 | 28 February 2019 |
| | | | | TW | 201914230 | A | 01 April 2019 |
| | | | | US | 2019058490 | A1 | 21 February 2019 |
| | | | | US | 10340950 | B2 | 02 July 2019 |
| | | | | EP | 3673595 | A1 | 01 July 2020 |
| | | | | EP | 3673595 | B1 | 01 June 2022 |
| CN | 115720124 | A | 28 February 2023 | WO | 2023024987 | A1 | 02 March 2023 |
| CN | 114337926 | A | 12 April 2022 | CN | 114337926 | B | 20 February 2024 |
| CN | 111447042 | A | 24 July 2020 | US | 2021344355 | A1 | 04 November 2021 |
| | | | | US | 11637569 | B2 | 25 April 2023 |
| | | | | WO | 2020147527 | A1 | 23 July 2020 |
| | | | | EP | 3910827 | A1 | 17 November 2021 |
| | | | | EP | 3910827 | A4 | 09 March 2022 |
| | | | | EP | 3910827 | B1 | 13 December 2023 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310709616